# EUROPEAN PATENT APPLICATION

(11) **EP 4 418 837 A1**
(43) Date of publication of application: **21.08.2024**
(21) Application number: 24156325.3
(22) Date of filing: 07.02.2024
(51) Int. Cl.: H10K 59/122, H10K 59/80

(54) **DISPLAY PANEL AND METHOD OF MANUFACTURING THE SAME**

(30) Priority: 14.02.2023 KR 20230019160
(71) Applicant: Samsung Display Co., Ltd., Gyeonggi-Do (KR)
(72) Inventor: Jo, Jungyun, Yongin-si, Gyeonggi-do (KR); Bae, Chulmin, Yongin-si, Gyeonggi-Do (KR); Sung, Woo Yong, Yongin-si, Gyeonggi-do (KR); Lee, Jeongseok, Yongin-si, Gyeonggi-Do (KR)
(74) Representative: Gulde & Partner

(57) **Abstract**

A display panel includes a base layer, a pixel definition layer which is disposed on the base layer and through which a light-emitting opening is defined, a barrier wall which is disposed on the pixel definition layer and through which a barrier wall opening corresponding to the light-emitting opening is defined, and a light-emitting element disposed in the barrier wall opening and including an anode, an intermediate layer, and a cathode that contacts the barrier wall. The barrier wall includes a first barrier wall layer disposed on the pixel definition layer and defining a first area of the barrier wall opening and a second barrier wall layer disposed on the first barrier wall layer, including an organic material, and defining a second area of the barrier wall opening.

## Description

### BACKGROUND

### 1. Field

The disclosure relates to a display panel. More particularly, the disclosure relates to a display panel with improved display quality.

### 2. Description of the Related Art

Display devices, such as a television set, a monitor, a smart phone, and a tablet computer, that provide images to a user include a display panel to display the images. Various types of display panels, such as a liquid crystal display panel, an organic light-emitting display panel, an electrowetting display panel, and an electrophoretic display panel, are being developed.

The organic light-emitting display panel includes an anode, a cathode, and a light-emitting pattern. The light-emitting pattern is separated for each light-emitting area, and the cathode provides a common voltage to each light-emitting area.

### SUMMARY

The present invention is set out in the appended set of claims, wherein the drawings and respective description relate to advantageous embodiments thereof. It was an object of the present invention to provide a display panel with improved display quality.

An embodiment of the inventive concept provides a display panel including a base layer, a pixel definition layer which is disposed on the base layer and through which a light-emitting opening is defined, a barrier wall which is disposed on the pixel definition layer and through which a barrier wall opening corresponding to the light-emitting opening is defined, and a light-emitting element disposed in the barrier wall opening and including an anode, an intermediate layer, and a cathode that contacts the barrier wall. The barrier wall includes a first barrier wall layer disposed on the pixel definition layer and defining a first area of the barrier wall opening and a second barrier wall layer disposed on the first barrier wall layer, including an organic material, and defining a second area of the barrier wall opening.

In an embodiment, the second barrier wall layer may include a light absorbing material.

In an embodiment, the second barrier wall layer may include a first sub-layer having a first refractive index and a second sub-layer disposed on the first sub-layer and having a second refractive index different from the first refractive index.

In an embodiment, the first refractive index of the first sub-layer and the second refractive index of the second sub-layer may be equal to or greater than about 1.5 and equal to or smaller than about 2.5.

In an embodiment, an inner side surface of the second barrier wall layer, which defines the second area, may be disposed closer to a center of the anode than an inner side surface of the first barrier wall layer, which defines the first area, is to the center of the anode in a cross-section.

In an embodiment, the barrier wall may have an undercut shape, and the cathode may contact an inner side surface of the first barrier wall layer, which defines the barrier wall opening.

In an embodiment, the barrier wall may further include a third barrier wall layer disposed between the first barrier wall layer and the second barrier wall layer, including an inorganic material, and defining the second area.

In an embodiment, a inner side surface of the third barrier wall layer, which defines the second area, may be aligned with an inner side surface of the second barrier wall layer, which defines the second area.

In an embodiment, the second barrier wall layer may have a refractive index different from a refractive index of the third barrier wall layer.

In an embodiment, the second barrier wall layer (L2) includes a light absorbing material.

In an embodiment, the second barrier wall layer may cover an upper surface of the third barrier wall layer.

An embodiment of the inventive concept provides a display panel including a base layer, a pixel definition layer which is disposed on the base layer and through which a light-emitting opening is defined, a barrier wall which is disposed on the pixel definition layer and through which a barrier wall opening corresponding to the light-emitting opening is defined, and a light-emitting element disposed in the barrier wall opening and including an anode, an intermediate layer, and a cathode that contacts the barrier wall. The barrier wall includes a first barrier wall layer disposed on the pixel definition layer and defining a first area of the barrier wall opening and a second barrier wall layer disposed on the first barrier wall layer, defining a second area of the barrier wall opening, and including a first sub-layer having a first refractive index and a second sub-layer disposed on the first sub-layer and having a second refractive index different from the first refractive index.

In an embodiment, the second barrier wall layer may include a light absorbing material.

In an embodiment, the second barrier wall layer may include an organic material.

In an embodiment, the first refractive index of the first sub-layer and the second refractive index of the second sub-layer may be equal to or greater than about 1.5 and equal to or smaller than about 2.5.

In an embodiment, an inner side surface of the second barrier wall layer, which defines the second area, may be disposed closer to a center of the anode than an inner side surface of the first barrier wall layer, which defines the first area, is to the center of the anode in a cross-section.

In an embodiment, the barrier wall may have an undercut shape, and the cathode may contact an inner side surface of the first barrier wall layer, which defines the barrier wall opening.

In an embodiment, the barrier wall may further include a third barrier wall layer disposed between the first barrier wall layer and the second barrier wall layer, including an inorganic material, and defining the second area.

In an embodiment, an inner side surface of the third barrier wall layer, which defines the second area, may be aligned with an inner side surface of the second barrier wall layer, which defines the second area.

In an embodiment, the second barrier wall layer may have a refractive index different from a refractive index of the third barrier wall layer.

In an embodiment, the second barrier wall layer may cover an upper surface of the third barrier wall layer.

An embodiment of the inventive concept provides a method of manufacturing display panel includes providing a preliminary display panel including a base layer, an anode disposed on the base layer, and a pixel definition layer which is disposed on the base layer and through which a light-emitting opening is defined to expose a portion of the anode, forming a first preliminary barrier wall layer on the preliminary display panel, forming a second preliminary barrier wall layer including an organic material on the first preliminary barrier wall layer, etching the first and second preliminary barrier wall layers to form a barrier wall through which a barrier wall opening is defined, and forming a light-emitting pattern and a cathode in the barrier wall opening, the cathode being in contact with the barrier wall.

In an embodiment, the forming the second preliminary barrier wall layer may include forming a first preliminary sub-layer having a first refractive index on the first preliminary barrier wall layer and forming a second preliminary sub-layer having a second refractive index different from the first refractive index on the first preliminary sub-layer.

In an embodiment, the etching the first and second preliminary barrier wall layers to form the barrier wall through which the barrier wall opening is defined may include first etching the first and second preliminary barrier wall layers and second etching the first preliminary barrier wall layer to form a first barrier wall layer and a second barrier wall layer. The first barrier wall layer may define a first area of the barrier wall opening, and the second barrier wall layer may define a second area having a width different from a width of the first area of the barrier wall opening.

In an embodiment, the method of manufacturing display panel may further include forming a third preliminary barrier wall layer on the first preliminary barrier wall layer and etching the third preliminary barrier wall layer to form the barrier wall through which the barrier wall opening is defined. The forming the barrier wall may include first etching the first preliminary barrier wall layer, the second preliminary barrier wall layer, and the third preliminary barrier wall layer and second etching the first preliminary barrier wall layer to form a first barrier wall layer, a second barrier wall layer, and a third barrier wall layer. The first barrier wall layer may define a first area of the barrier wall opening, and the second barrier wall layer and the third barrier wall layer may define a second area having a width different from a width of the first area of the barrier wall opening.

According to the above, the barrier wall includes a plurality of barrier wall layers. The barrier wall layer (hereinafter, also referred to as the second barrier wall layer) disposed at an uppermost position among the barrier wall layers includes a light absorbing material. In addition, the second barrier wall layer includes the first sub-layer having the first refractive index and the second sub-layer having the second refractive index different from the first refractive index, and thus, a destructive interference is generated by controlling the refractive index and the thickness of the first and second sub-layers. Accordingly, a reflectance on an upper surface of the second barrier wall layer, which corresponds to an upper surface of the barrier wall, is reduced, and thus, the display quality of the display panel is improved.

In addition, the second barrier wall layer has strong resistance to a chemical etching. Since the second barrier wall layer is disposed at the uppermost position, damages caused by the etching process on the barrier wall are reduced. That is, it is possible to prevent a loss of the tip portion formed in the barrier wall and an exposure of an upper surface of the first barrier wall layer disposed under the second barrier wall layer, which is caused by the etching process.

### BRIEF DESCRIPTION OF THE DRAWINGS

The above and other advantages of the disclosure will become readily apparent by reference to the following detailed description when considered in conjunction with the accompanying drawings, in which:
FIG. 1A is a perspective view of an embodiment of a display device according to the disclosure;
FIG. 1B is an exploded perspective view of an embodiment of a display device according to the disclosure;
FIG. 2 is a cross-sectional view of an embodiment of a display module according to the disclosure;
FIG. 3 is a plan view of an embodiment of a display panel according to the disclosure;
FIG. 4 is an equivalent circuit diagram of an embodiment of a pixel according to the disclosure;
FIG. 5 is an enlarged plan view of an embodiment of a portion of a display area of a display panel according to the disclosure;
FIG. 6 is a cross-sectional view of an embodiment of a display panel taken along line I-I' of FIG. 5 according to the disclosure;
FIG. 7 is a cross-sectional view of an embodiment of a display panel taken along line I-I' of FIG. 5 according to the disclosure;
FIGS. 8A to 8I are cross-sectional views illustrating an embodiment of a method of manufacturing a display panel according to the disclosure; and
FIGS. 9A to 9D are cross-sectional views illustrating an embodiment of a method of manufacturing a display panel according to the disclosure.

### DETAILED DESCRIPTION

In the disclosure, it will be understood that when an element (or area, layer, or portion) is also referred to as being "on", "connected to" or "coupled to" another element or layer, it may be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the disclosure. As used herein, the singular forms, "a", "an" and "the" are intended to include the plural forms as well, unless the context clearly indicates otherwise.

Spatially relative terms, such as "beneath", "below", "lower", "above", "upper" or the like, may be used herein for ease of description to describe one element or feature's relationship to another elements or features as shown in the drawing figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the disclosure will be described with reference to accompanying drawings.

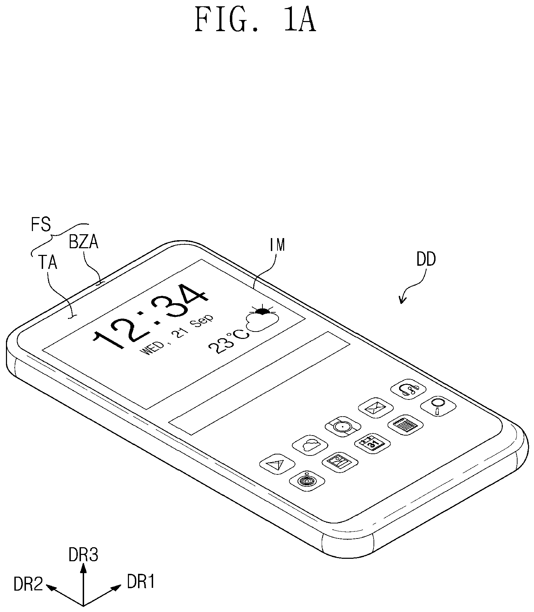

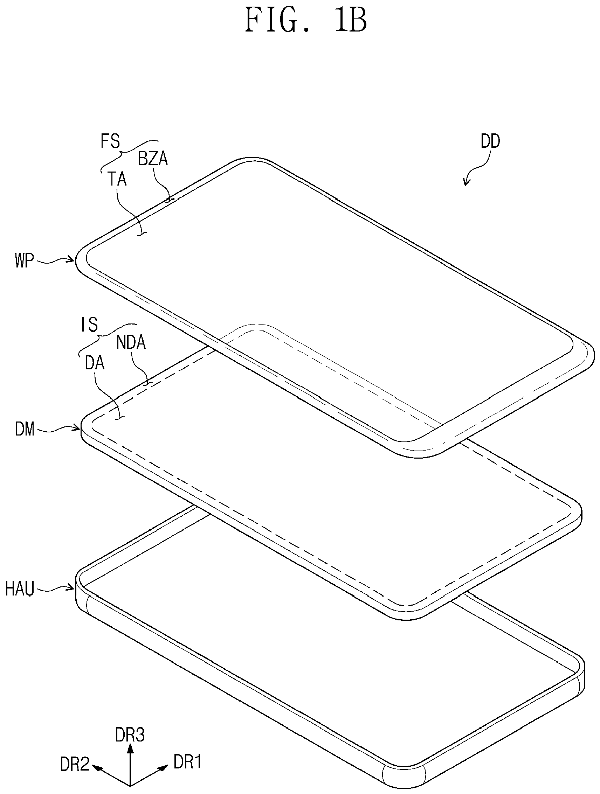

FIG. 1A is a perspective view of an embodiment of a display device DD according to the disclosure, and FIG. 1B is an exploded perspective view of an embodiment of the display device DD according to the disclosure.

The display device DD may be applied to a large-sized electronic item, such as a television set, a monitor, or an outdoor billboard. In addition, the display device DD may be applied to a small and medium-sized electronic item, such as a personal computer, a notebook computer, a personal digital assistant, a car navigation unit, a game unit, a smartphone, a tablet computer, and a camera. However, these are merely illustrative embodiments, and the display device DD may be employed in other display devices as long as they do not deviate from the concept of the disclosure. In the illustrated embodiment, the smartphone will be described as an illustrative embodiment of the display device DD.

Referring to FIGS. 1A and 1B, the display device DD may display an image IM through a display surface FS, which is substantially parallel to each of a first direction DR1 and a second direction DR2, toward a third direction DR3. The image IM may include a video and a still image. FIG. 1A shows a clock widget and application icons as an illustrative embodiment of the image IM. The display surface FS through which the image IM is displayed may correspond to a front surface of the display device DD.

In the illustrated embodiment, front (or upper) and rear (or lower) surfaces of each member of the display device DD may be defined with respect to a direction in which the image IM is displayed. The front and rear surfaces may be opposite to each other in the third direction DR3, and a normal line direction of each of the front and rear surfaces may be substantially parallel to the third direction DR3. Directions indicated by the first, second, and third directions DR1, DR2, and DR3 may be relative to each other, and thus, the directions indicated by the first, second, and third directions DR1, DR2, and DR3 may be changed to other directions. In the following descriptions, the expression "in a plan view" means a state of being viewed in the third direction DR3.

The display device DD may include a window WP, a display module DM, and a housing HAU. The window WP and the housing HAU may be coupled to each other to provide an exterior of the display device DD.

The window WP may include an optically transparent insulating material. In an embodiment, the window WP may include a glass or plastic material. A front surface of the window WP may define the display surface FS of the display device DD, for example. The display surface FS may include a transmissive area TA and a bezel area BZA. The transmissive area TA may be an optically transparent area. In an embodiment, the transmissive area TA may be an area having a visible light transmittance of about 90% or more.

The bezel area BZA may be an area having a relatively lower transmittance than that of the transmissive area TA. The bezel area BZA may define a shape of the transmissive area TA. The bezel area BZA may be disposed adj acent to the transmissive area TA and may surround the transmissive area TA. However, this is merely one example, and the bezel area BZA may be omitted from the window WP. The window WP may include at least one functional layer of an anti-fingerprint layer, a hard coating layer, and an anti-reflective layer and should not be particularly limited.

The display module DM may be disposed under the window WP. The display module DM may have a configuration that substantially generates the image IM. The image IM generated by the display module DM may be displayed through a display surface IS of the display module DM and may be viewed by a user through the transmission area TA.

The display module DM may include a display area DA and a non-display area NDA. The display area DA may be activated in response to electrical signals. The non-display area NDA may be adjacent to the display area DA. The non-display area NDA may surround the display area DA. The non-display area NDA may be covered by the bezel area BZA and may not be viewed from the outside.

The housing HAU may be coupled with the window WP. The housing HAU and the window WP, which are coupled to each other, may provide a predetermined inner space. The display module DM may be accommodated in the inner space.

The housing HAU may include a material with a relatively high rigidity. In an embodiment, the housing HAU may include a plurality of frames and/or plates formed of a glass, plastic, or metal material or combinations thereof. The housing HAU may stably protect the components of the display device DD accommodated in the inner space from external impacts.

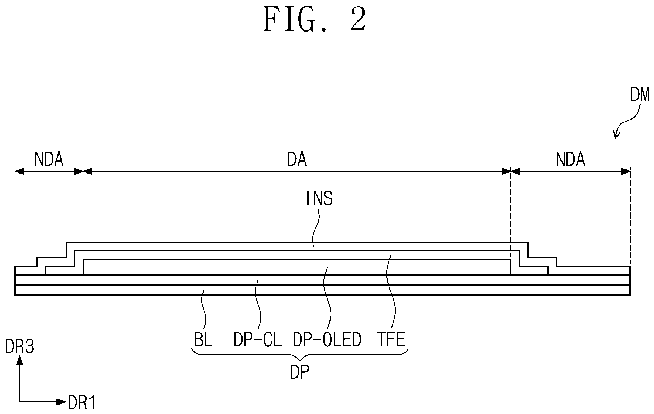

FIG. 2 is a cross-sectional view of an embodiment of the display module DM according to the disclosure.

Referring to FIG. 2, the display module DM may include a display panel DP and an input sensor INS. Although not shown in drawing figures, the display device DD (refer to FIG. 1A) may include a protective member disposed on a lower surface of the display panel DP or an anti-reflective member and/or a window member disposed on an upper surface of the input sensor INS.

The display panel DP may be a light-emitting type display panel, however, it should not be particularly limited. In an embodiment, the display panel DP may be an organic light-emitting display panel or an inorganic light-emitting display panel, for example. A light-emitting layer of the organic light-emitting display panel may include an organic light-emitting material. A light-emitting layer of the inorganic light-emitting display panel may include a quantum dot, a quantum rod, or a micro-LED. The organic light-emitting display panel will be described as the display panel DP.

The display panel DP may include a base layer BL, a circuit element layer DP-CL, a display element layer DP-OLED, and a thin film encapsulation layer TFE. The circuit element layer DP-CL, the display element layer DP-OLED, and the thin film encapsulation layer TFE may be disposed on the base layer BL. The input sensor INS may be disposed directly on the thin film encapsulation layer TFE. In the disclosure, the expression "a component A is disposed directly on a component B" means that no adhesive layers are present between the component B and the component A.

The base layer BL may include at least one plastic film. The base layer BL may be a flexible substrate and may include a plastic substrate, a glass substrate, a metal substrate, or an organic/inorganic composite material substrate. The display area DA and the non-display area NDA described with reference to FIG. 1B may be defined equally in the base layer BL.

The circuit element layer DP-CL may include at least one insulating layer and a circuit element. The insulating layer may include at least one inorganic layer and at least one organic layer. The circuit element may include signal lines and a pixel driving circuit.

The display element layer DP-OLED may include a barrier wall and a light-emitting element. The light-emitting element may include an anode, an intermediate layer, and a cathode.

The thin film encapsulation layer TFE may include a plurality of thin layers. Some thin layers may be disposed to improve an optical efficiency, and some thin layers may be disposed to protect organic light-emitting diodes.

The input sensor INS may obtain coordinate information of an external input. The input sensor INS may have a multi-layer structure. The input sensor INS may include a conductive layer having a single-layer or multi-layer structure. The input sensor INS may include an insulating layer having a single-layer or multi-layer structure. The input sensor INS may sense the external input by a capacitive method, however, the disclosure should not be limited thereto or thereby. In an embodiment, the input sensor INS may sense the external input by an electromagnetic induction method or a pressure sensing method. In an embodiment, the input sensor INS may be omitted.

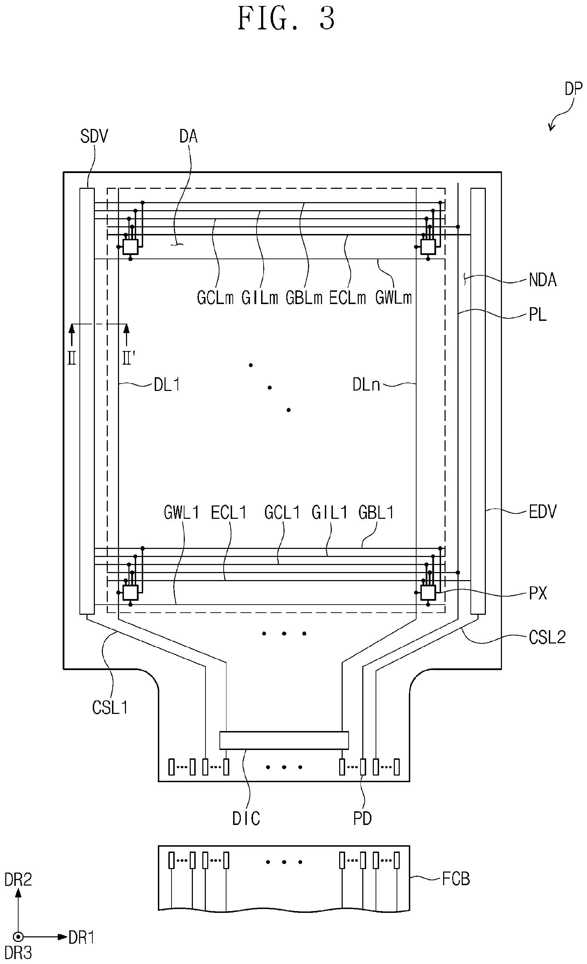

FIG. 3 is a plan view of an embodiment of the display panel DP according to the disclosure.

Referring to FIG. 3, the display panel DP may include the display area DA and the non-display area NDA around the display area DA. The display area DA and the non-display area NDA may be distinguished from each other by a presence or absence of pixels PX. The pixels PX may be disposed in the display area DA. A scan driver SDV, a data driver, and an emission driver EDV may be disposed in the non-display area NDA. The data driver may be a circuit provided in a driving chip DIC.

The display panel DP may include the pixels PX, a plurality of initialization scan lines GIL1 to GILm, a plurality of compensation scan lines GCL1 to GCLm, a plurality of write scan lines GWL1 to GWLm, a plurality of black scan lines GBL1 to GBLm, a plurality of emission control lines ECL1 to ECLm, a plurality of data lines DL1 to DLn, first and second control lines CSL1 and CSL2, a driving voltage line PL, and a plurality of pads PD. In the illustrated embodiment, each of "m" and "n" is a natural number equal to or greater than 2.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL1 to GBLm may extend in the first direction DR1 and may be electrically connected to the scan driver SDV. The data lines DL1 to DLn may extend in the second direction DR2 and may be electrically connected to the driving chip DIC. The emission control lines ECL1 to ECLm may extend in the first direction DR1 and may be electrically connected to the emission driver EDV.

The driving voltage line PL may include a portion extending in the first direction DR1 and a portion extending in the second direction DR2. The portion extending in the first direction DR1 and the portion extending in the second direction DR2 may be disposed in different layers from each other. The driving voltage line PL may provide a driving voltage to the pixels PX.

The first control line CSL1 may be connected to the scan driver SDV. The second control line CSL2 may be connected to the emission driver EDV.

The driving chip DIC, the driving voltage line PL, the first control line CSL1, and the second control line CSL2 may be electrically connected to the pads PD. A flexible circuit film FCB may be electrically connected to the pads PD through an anisotropic conductive adhesive layer.

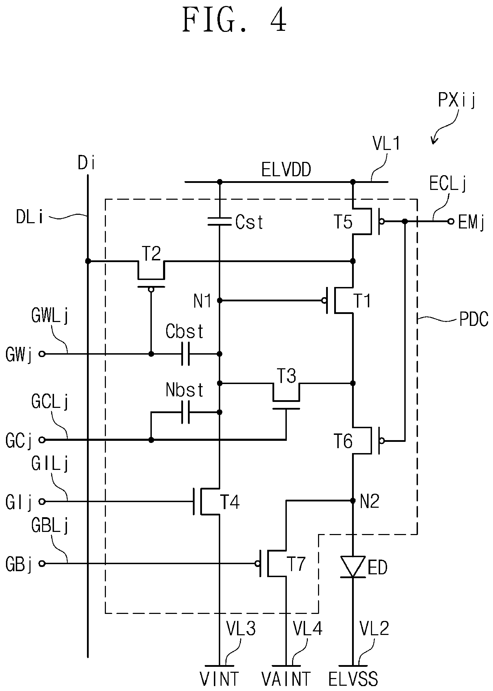

FIG. 4 is an equivalent circuit diagram of an embodiment of a pixel PXij according to the disclosure.

FIG. 4 shows an equivalent circuit diagram of the pixel PXij among the pixels PX of FIG. 3. Since the pixels PX may have substantially the same configuration as each other, the circuit configuration of the pixel PXij will be described in detail, and detailed descriptions of the other pixels will be omitted.

Referring to FIGS. 3 and 4, the pixel PXij may be connected to an i-th data line DLi among the data lines DL1 to DLn, a j-th initialization scan line GILj among the initialization scan lines GIL1 to GILm, a j-th compensation scan line GCLj among the compensation scan lines GCL1 to GCLm, a j-th write scan line GWLj among the write scan lines GWL1 to GWLm, a j-th black scan line GBLj among the black scan lines GBL1 to GBLm, a j-th emission control line ECLj among the emission control lines ECL1 to ECLm, first and second driving voltage lines VL1 and VL2, and first and second initialization voltage lines VL3 and VL4. The "i" may be an integer number equal to or greater than 1 and equal to or smaller than n, and the " j" may be an integer number equal to or greater than 1 and equal to or smaller than m.

The pixel PXij may include a light-emitting element ED and a pixel circuit PDC. The light-emitting element ED may be a light-emitting diode. In an embodiment, the light-emitting element ED may be an organic light-emitting diode including an organic light-emitting layer, however, it should not be particularly limited. The pixel circuit PDC may control an amount of current flowing through the light-emitting element ED in response to a data signal Di. The light-emitting element ED may emit a light with a predetermined luminance corresponding to the amount of current provided from the pixel circuit PDC.

In an embodiment, the light-emitting element ED may be disposed in the barrier wall opening OP-P/OP-Pa and may comprise an anode AE, an intermediate layer, and a cathode CE which contacts the barrier wall PW/PWa.

The pixel circuit PDC may include first, second, third, fourth, fifth, sixth, and seventh transistors T1, T2, T3, T4, T5, T6, and T7 and first, second, and third capacitors Cst, Cbst, and Nbst. The configuration of the pixel circuit PDC should not be limited to the embodiment shown in FIG. 4. The pixel circuit PDC shown in FIG. 4 is merely one of embodiments, and the configuration of the pixel circuit PDC may be changed.

At least one of the first to seventh transistors T1 to T7 may include a low-temperature polycrystalline silicon ("LTPS") as its semiconductor layer. At least one of the first to seventh transistors T1 to T7 may include an oxide material as its semiconductor layer. In an embodiment, each of the third and fourth transistors T3 and T4 may be an oxide semiconductor transistor, and each of the first, second, fifth, sixth, and seventh transistors T1, T2, T5, T6, and T7 may be a low-temperature polycrystalline silicon ("LTPS") transistor.

In detail, the first transistor T1, which directly affects a luminance of the light-emitting element ED, may include the semiconductor layer including or consisting of polycrystalline silicon with relatively high reliability, and thus, the display device with relatively high resolution may be implemented. Since the oxide semiconductor has a relatively high carrier mobility and a relatively low leakage current, the voltage drop is not relatively large even though the driving time is long. That is, even when the pixels PX are driven at relatively low frequency, a change in color of the image due to the voltage drop is not large, and thus, the pixels PX may be driven at relatively low frequency. As described above, since the oxide semiconductor has relatively low leakage current, at least one of the third transistor T3 and the fourth transistor T4, which are connected to a gate electrode of the first transistor T1, may include the oxide semiconductor. Thus, the leakage current may be prevented from flowing to the gate electrode of the first transistor T1, and power consumption may be reduced.

Some of the first to seventh transistors T1 to T7 may be a P-type transistor, and the other of the first to seventh transistors T1 to T7 may be an N-type transistor. In an embodiment, each of the first, second, fifth, sixth, and seventh transistors T1, T2, T5, T6, and T7 may be the P-type transistor, and each of the third and fourth transistors T3 and T4 may be the N-type transistor.

The configuration of the pixel circuit PDC should not be limited to that shown in FIG. 4. The pixel circuit PDC shown in FIG. 4 is merely one of embodiments, and the configuration of the pixel circuit PDC may be changed. In an embodiment, all the first to seventh transistors T1 to T7 may be the P-type transistor or the N-type transistor. In an embodiment, the first, second, fifth, and sixth transistors T1, T2, T5, and T6 may be the P-type transistor, and the third, fourth, and seventh transistors T3, T4, and T7 may be the N-type transistor.

The j-th initialization scan line GILj, the j-th compensation scan line GCLj, the j-th write scan line GWLj, the j-th black scan line GBLj, and the j-th emission control line ECLj may transmit a j-th initialization scan signal GIj, a j-th compensation scan signal GCj, a j-th write scan signal GWj, a j-th black scan signal GBj, and a j-th emission control signal EMj to the pixel PXij, respectively. The i-th data line DLi may transmit an i-th data signal Di to the pixel PXij. The i-th data signal Di may have a voltage level corresponding to the image signal input to the display device DD (refer to FIGS. 1A and 1B).

The first and second driving voltage lines VL1 and VL2 may transmit a first driving voltage ELVDD and a second driving voltage ELVSS to the pixel PXij, respectively. In addition, the first and second initialization voltage lines VL3 and VL4 may transmit a first initialization voltage VINT and a second initialization voltage VAINT to the pixel PXij, respectively.

The first transistor T1 may be connected between the first driving voltage line VL1 receiving the first driving voltage ELVDD and the light-emitting element ED. The first transistor T1 may include a first electrode connected to the first driving voltage line VL1 via the fifth transistor T5, a second electrode electrically connected to a pixel electrode (or referred to as an anode) of the light-emitting element ED via the sixth transistor T6, and a third electrode (e.g., the gate electrode) connected to one end (e.g., a first node N1) of the first capacitor Cst. The first transistor T1 may receive the i-th data signal Di transmitted by the i-th data line DLi in response to a switching operation of the second transistor T2 and may supply a driving current to the light-emitting element ED.

The second transistor T2 may be connected between the i-th data line DLi and the first electrode of the first transistor T1. The second transistor T2 may include a first electrode connected to the i-th data line DLi, a second electrode connected to the first electrode of the first transistor T1, and a third electrode (e.g., a gate electrode) connected to the j-th write scan line GWLj. The second transistor T2 may be turned on in response to the j-th write scan signal GWj applied thereto via the j-th write scan line GWLj and may transmit the i-th data signal Di applied thereto via the i-th data line DLi to the first electrode of the first transistor T1. One end of the second capacitor Cbst may be connected to the third electrode of the second transistor T2, and the other end of the second capacitor Cbst may be connected to the first node N1.

The third transistor T3 may be connected between the second electrode of the first transistor T1 and the first node N1. The third transistor T3 may include a first electrode connected to the third electrode of the first transistor T1, a second electrode connected to the second electrode of the first transistor T1, and a third electrode (e.g., a gate electrode) connected to the j-th compensation scan line GCLj. The third transistor T3 may be turned on in response to the j-th compensation scan signal GCj applied thereto via the j-th compensation scan line GCLj and may connect the third electrode and the second electrode of the first transistor T1 to each other to allow the first transistor T1 to be connected in a diode configuration. One end of the third capacitor Nbst may be connected to the third electrode of the third transistor T3, and the other end of the third capacitor Nbst may be connected to the first node N1.

The fourth transistor T4 may be connected between the first initialization voltage line VL3 to which the first initialization voltage VINT is applied and the first node N1. The fourth transistor T4 may include a first electrode connected to the first initialization voltage line VL3 to which the first initialization voltage VINT is applied, a second electrode connected to the first node N1, and a third electrode (e.g., a gate electrode) connected to the j-th initialization scan line GILj. The fourth transistor T4 may be turned on in response to the j-th initialization scan signal GIj applied thereto via the j-th initialization scan line GILj. The turned-on fourth transistor T4 may transmit the first initialization voltage VINT to the first node N1 to initialize an electric potential of the third electrode of the first transistor T1, i.e., an electric potential of the first node N1.

The fifth transistor T5 may include a first electrode connected to the first driving voltage line VL1, a second electrode connected to the first electrode of the first transistor T1, and a third electrode (e.g., a gate electrode) connected to the j-th emission control line ECLj. The sixth transistor T6 may include a first electrode connected to the second electrode of the first transistor T1, a second electrode connected to the pixel electrode of the light-emitting element ED, and a third electrode (e.g., a gate electrode) connected to the j-th emission control line ECLj.

The fifth transistor T5 and the sixth transistor T6 may be substantially simultaneously turned on in response to the j-th emission control signal EMj applied thereto via the j-th emission control line ECLj. The first driving voltage ELVDD applied via the turned-on fifth transistor T5 may be compensated for by the first transistor T1 connected in the diode configuration and may be transmitted to the light-emitting element ED via the sixth transistor T6.

The seventh transistor T7 may include a first electrode connected to the second initialization voltage line VL4 to which the second initialization voltage VAINT is applied, a second electrode connected to the second electrode of the sixth transistor T6, and a third electrode (e.g., a gate electrode) connected to the j-th black scan line GBLj. The second initialization voltage VAINT may have a voltage level equal to or lower than that of the first initialization voltage VINT.

The one end of the first capacitor Cst may be connected to the third electrode of the first transistor T1, and the other end of the first capacitor Cst may be connected to the first driving voltage line VL1. A cathode of the light-emitting element ED may be connected to the second driving voltage line VL2 that transmits the second driving voltage ELVSS. The second driving voltage ELVSS may have a voltage level lower than that of the first driving voltage ELVDD.

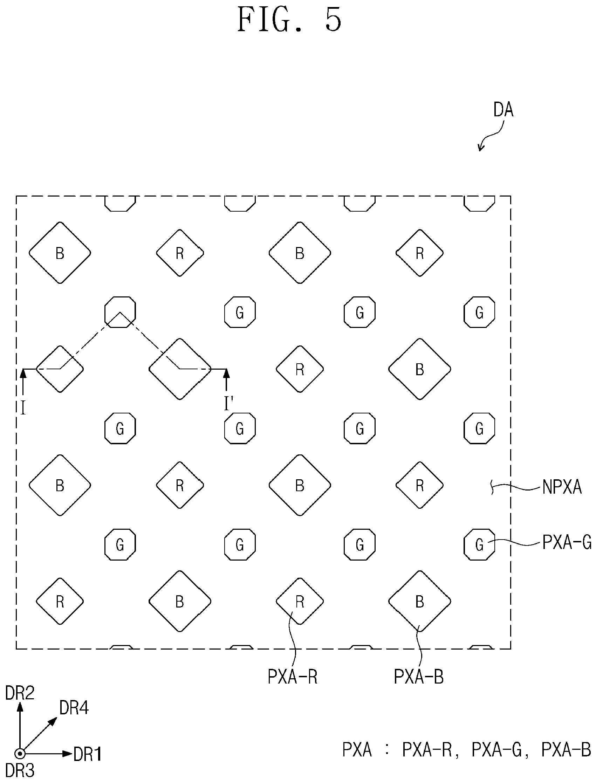

FIG. 5 is an enlarged plan view of an embodiment of a portion of the display area DA (refer to FIG. 2) of the display panel DP (refer to FIG. 2) according to the disclosure. FIG. 5 is a plan view showing the display module DM (refer to FIG. 1B) when viewed from an upper side of the display surface IS (refer to FIG. 1B) of the display module DM (refer to FIG. 2) and shows an arrangement of light-emitting areas PXA-R, PXA-G, and PXA-B.

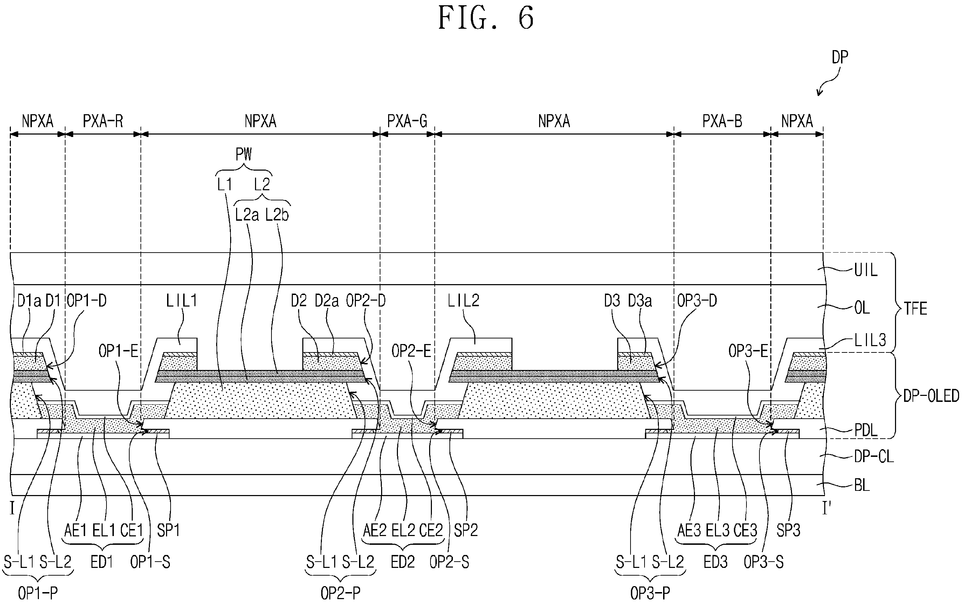

Referring to FIG. 5, the display area DA may include first, second, and third light-emitting areas PXA-R, PXA-G, and PXA-B and a peripheral area NPXA surrounding the first, second, and third light-emitting areas PXA-R, PXA-G, and PXA-B. The first, second, and third light-emitting areas PXA-R, PXA-G, and PXA-B may respectively correspond to areas from which lights provided from light-emitting elements ED1, ED2, and ED3 (refer to FIG. 6) are emitted. The first, second, and third light-emitting areas PXA-R, PXA-G, and PXA-B may be distinguished by colors of the lights emitted outward from the display module DM (refer to FIG. 2).

The first, second, and third light-emitting areas PXA-R, PXA-G, and PXA-B may respectively provide first, second, and third color lights having colors different from each other. In an embodiment, the first color light may be a red light, the second color light may be a green light, and the third color light may be a blue light. However, the first, second, and third color lights should not be limited thereto or thereby.

Each of the first, second, and third light-emitting areas PXA-R, PXA-G, and PXA-B may be defined as an area through which an upper surface of the anode is exposed by a light-emitting opening described later. The peripheral area NPXA may define a boundary between the first, second, and third light-emitting areas PXA-R, PXA-G, and PXA-B and may prevent a mixture of the colors of the lights traveling between the first, second, and third light-emitting areas PXA-R, PXA-G, and PXA-B.

Each of the first, second, and third light-emitting areas PXA-R, PXA-G, and PXA-B may be provided in plural and may be repeatedly arranged in a predetermined arrangement within the display area DA. In an embodiment, the first and third light-emitting areas PXA-R and PXA-B may be alternately arranged with each other in the first direction DR1 to form a first group. The second light-emitting areas PXA-G may be arranged in the first direction DR1 to form a second group. Each of the first group and the second group may be provided in plural, and the first groups may be alternately arranged with the second groups in the second direction DR2.

One second light-emitting area PXA-G may be disposed spaced apart from one first light-emitting area PXA-R or one third light-emitting area PXA-B in a fourth direction DR4. The fourth direction DR4 may correspond to a direction between the first and second directions DR1 and DR2.

FIG. 5 shows an illustrative embodiment of the arrangement of the first, second, and third light-emitting areas PXA-R, PXA-G, and PXA-B, however, the arrangement of the first, second, and third light-emitting areas PXA-R, PXA-G, and PXA-B should not be particularly limited and may be changed in various ways. The first, second, and third light-emitting areas PXA-R, PXA-G, and PXA-B may be arranged in a pentile pattern (PENTILE^{™}) as shown in FIG. 5. In an embodiment, the first, second, and third light-emitting areas PXA-R, PXA-G, and PXA-B may be arranged in a stripe pattern or a diamond pattern (Diamond Pixel^{™}).

Each of the first, second, and third light-emitting areas PXA-R, PXA-G, and PXA-B may have a variety of shapes in a plan view. In an embodiment, each of the first, second, and third light-emitting areas PXA-R, PXA-G, and PXA-B may have a polygonal shape, a circular shape, or an oval shape. In FIG. 5, the first and third light-emitting areas PXA-R and PXA-B each having a quadrangular shape or a lozenge shape and the second light-emitting area PXA-G having an octagonal shape are shown as an illustrative embodiment.

The first, second, and third light-emitting areas PXA-R, PXA-G, and PXA-B may have substantially the same shape as each other when viewed in the plane, or at least one of the first, second, and third light-emitting areas PXA-R, PXA-G, and PXA-B may have a shape different from the others. FIG. 5 shows a structure in which the first and third light-emitting areas PXA-R and PXA-B have the same shape as each other when viewed in the plane and the second light-emitting area PXA-G has the shape different from that of the first and third light-emitting areas PXA-R and PXA-B as an illustrative embodiment.

At least one of the first, second, and third light-emitting areas PXA-R, PXA-G, and PXA-B may have a size different from those of the others when viewed in the plane. The size of the first light-emitting area PXA-R emitting the red light may be greater than the size of the second light-emitting area PXA-G emitting the green light and may be smaller than the size of the third light-emitting area PXA-B emitting the blue light. However, a size relationship between the first, second, and third light-emitting areas PXA-R, PXA-G, and PXA-B according to the colors of the lights should not be limited thereto or thereby and may be changed in various ways depending on a design of the display module DM (refer to FIG. 2). In addition, in an embodiment, the first, second, and third light-emitting areas PXA-R, PXA-G, and PXA-B may have substantially the same size as each other when viewed in the plane.

The shape, size, and arrangement of the first, second, and third light-emitting areas PXA-R, PXA-G, and PXA-B of the display module DM (refer to FIG. 2) may be variously designed depending on the colors of the emitted lights, the size of the display module DM (refer to FIG. 2), and the configuration of the display module DM (refer to FIG. 2), however, they should not be limited to the embodiment shown in FIG. 5.

FIG. 6 is a cross-sectional view of an embodiment of the display panel DP taken along line I-I' of FIG. 5 according to the disclosure.

Referring to FIG. 6, the display panel DP may include the base layer BL, the circuit element layer DP-CL, the display element layer DP-OLED, and the thin film encapsulation layer TFE.

The display panel DP may include a plurality of insulating layers, a semiconductor pattern, a conductive pattern, and a signal line. An insulating layer, a semiconductor layer, and a conductive layer may be formed by a coating or depositing process. Then, the insulating layer, the semiconductor layer, and the conductive layer may be selectively patterned by a photolithography process. The semiconductor pattern, the conductive pattern, and the signal line, which are included in the circuit element layer DP-CL and the display element layer DP-OLED, may be formed through the above processes.

The circuit element layer DP-CL may be disposed on the base layer BL. The circuit element layer DP-CL is shown as a single layer, but this is for ease of explanation. The circuit element layer DP-CL may include an insulating layer, a semiconductor pattern, a conductive pattern, or the like to form various elements.

A driving circuit of the pixel in the circuit element layer DP-CL may be provided in plural, and the driving circuits may be respectively connected to the light-emitting elements ED1, ED2, and ED3 and may independently control the light-emitting elements ED1, ED2, and ED3. Each of the driving circuits of the pixel may include a plurality of transistors, at least one capacitor, and signal lines connecting the transistors and the capacitor to drive the light-emitting element.

The display element layer DP-OLED may be disposed on the circuit element layer DP-CL. The display element layer DP-OLED may include the light-emitting elements ED1, ED2, and ED3, a pixel definition layer PDL, a barrier wall PW, dummy patterns D1, D2, and D3, and additional dummy patterns D1a, D2a, and D3a.

The light-emitting elements ED1, ED2, and ED3 may include a first light-emitting element ED1, a second light-emitting element ED2, and a third light-emitting element ED3, and each of the first, second, and third light-emitting elements ED1, ED2, and ED3 may include an anode (or a first electrode), a cathode (or a second electrode), and a light-emitting pattern disposed between the anode and the cathode. The first light-emitting element ED1 may include a first anode AE1, a first cathode CE1, and a first light-emitting pattern EL1, the second light-emitting element ED2 may include a second anode AE2, a second cathode CE2, and a second light-emitting pattern EL2, and the third light-emitting element ED3 may include a third anode AE3, a third cathode CE3, and a third light-emitting pattern EL3.

The first, second, and third anodes AE1, AE2, and AE3 may be provided with a plurality of patterns. The first, second, and third anodes AE1, AE2, and AE3 may have a conductivity. In an embodiment, each of the anodes AE1, AE2, and AE3 may include or consist of various materials having a conductivity, such as metals, transparent conductive oxides ("TCOs"), or conductive polymer materials. In an embodiment, the metals may include gold (Au), silver (Ag), aluminum (Al), magnesium (Mg), lithium (Li), molybdenum (Mo), copper (Cu), or alloys. The transparent conductive oxides may include indium tin oxide ("ITO"), indium zinc oxide ("IZO"), zinc oxide, indium oxide, indium gallium oxide, or aluminum zinc oxide.

Each of the first, second, and third anodes AE1, AE2, and AE3 may have a single-layer structure, however, this is merely one of embodiments, and each of the first, second, and third anodes AE1, AE2, and AE3 may have a multi-layer structure. In an embodiment, one anode of the first, second, and third anodes AE1, AE2, and AE3 may have the single-layer structure, and another anode of the first, second, and third anodes AE1, AE2, and AE3 may have the multi-layer structure, however, they should not be particularly limited.

The first, second, and third light-emitting patterns EL1, EL2, and EL3 may be respectively disposed on the first, second, and third anodes AE1, AE2, and AE3. The first, second, and third light-emitting patterns EL1, EL2, and EL3 may be patterned by a tip portion defined by the barrier wall PW described later.

The first light-emitting pattern EL1 may provide a red light, the second light-emitting pattern EL2 may provide a green light, and the third light-emitting pattern EL3 may provide a blue light.

Each of the first, second, and third light-emitting patterns EL1, EL2, and EL3 may include a light-emitting layer including or consisting of a light-emitting material. Each of the first, second, and third light-emitting patterns EL1, EL2, and EL3 may further include a hole injection layer ("HIL") and a hole transport layer ("HTL"), which are disposed between a corresponding anode among the first, second, and third anodes AE1, AE2, and AE3 and the light-emitting layer and may further include an electron transport layer ("ETL") and an electron injection layer ("EIL"), which are disposed on the light-emitting layer. The first, second, and third light-emitting patterns EL1, EL2, and EL3 may be respectively referred to as first, second, and third organic layers or first, second, and third intermediate layers.

Each of the first, second, and third cathodes CE1, CE2, and CE3 may be disposed on a corresponding light-emitting pattern among the first, second, and third light-emitting patterns EL1, EL2, and EL3. The first, second, and third cathodes CE1, CE2, and CE3 may be patterned by the tip portion defined by the barrier wall PW described later.

The pixel definition layer PDL may be disposed on an insulating layer disposed at an uppermost position of the circuit element layer DP-CL. First, second, and third light-emitting openings OP1-E, OP2-E, and OP3-E may be defined through the pixel definition layer PDL. The first, second, and third light-emitting openings OP1-E, OP2-E, and OP3-E may respectively correspond to the first, second, and third anodes AE1, AE2, and AE3. At least a portion of each of the anodes AE1, AE2, and AE3 may be exposed through a corresponding light-emitting opening among the light-emitting openings OP1-E, OP2-E, and OP3-E of the pixel definition layer PDL.

In an embodiment, the pixel definition layer PDL may be disposed on the base layer BL.

The first light-emitting area PXA-R may be defined as an area where an upper surface of the first anode AE1 is exposed through the first light-emitting opening OP1-E, the second light-emitting area PXA-G may be defined as an area where an upper surface of the second anode AE2 is exposed through the second light-emitting opening OP2-E, and the third light-emitting area PXA-B may be defined as an area where an upper surface of the third anode AE3 is exposed through the third light-emitting opening OP3-E.

The pixel definition layer PDL may be an inorganic insulating layer. In an embodiment, the pixel definition layer PDL may include silicon oxide, silicon nitride, or any combinations thereof. In an embodiment, the pixel definition layer PDL may have a two-layer structure in which a silicon oxide layer and a silicon nitride layer are sequentially stacked, however, this is merely one of embodiments. The layer structure of the pixel definition layer PDL, e.g., whether the pixel definition layer has the single-layer or multi-layer structure, and the material of the pixel definition layer PDL should not be particularly limited as long as the pixel definition layer PDL is the inorganic insulating layer.

In an embodiment, the display panel DP may further include first, second, and third sacrificial patterns SP1, SP2, and SP3. The first, second, and third sacrificial patterns SP1, SP2, and SP3 may be respectively disposed on upper surfaces of the first, second, and third anodes AE1, AE2, and AE3. The sacrificial patterns SP1, SP2, and SP3 may be covered by the pixel definition layer PDL. Each of the sacrificial patterns SP1, SP2, and SP3 may expose at least a portion of a corresponding anode of the anodes AE1, AE2, and AE3. The sacrificial patterns SP1, SP2, and SP3 may be respectively disposed at positions that do not overlap the light-emitting openings OP1-E, OP2-E, and OP3-E.

In the case where the display panel DP further includes the sacrificial patterns SP1, SP2, and SP3, each of the upper surfaces of the anodes AE1, AE2, and AE3 may be spaced apart from the pixel definition layer PDL with a corresponding sacrificial pattern among the sacrificial patterns SP1, SP2, and SP3 interposed therebetween when viewed in a cross-section. Accordingly, the anodes AE1, AE2, and AE3 may be prevented from being damaged in a process of forming the light-emitting openings OP1-E, OP2-E, and OP3-E.

Sacrificial openings OP1-S, OP2-S, and OP3-S may be defined respectively through the sacrificial patterns SP1, SP2, and SP3 to respectively correspond to the light-emitting openings OP1-E, OP2-E, and OP3-E. Each of the sacrificial openings OP1-S, OP2-S, and OP3-S may have a size greater than a corresponding light-emitting opening among the light-emitting openings OP1-E, OP2-E, and OP3-E, however, it should not be limited thereto or thereby. In an embodiment, inner side surfaces of the sacrificial patterns SP1, SP2, and SP3 defining the sacrificial openings OP1-S, OP2-S, and OP3-S may be substantially aligned with inner side surfaces of the pixel definition layer PDL defining the corresponding light-emitting openings OP1-E, OP2-E, and OP3-E. In this case, each of the light-emitting areas PXA-R, PXA-G, and PXA-B may be an area of a corresponding anode among the anodes AE1, AE2, and AE3, which is exposed through a corresponding sacrificial opening among the sacrificial openings OP1-S, OP2-S, and OP3-S.

The barrier wall PW may be disposed on the pixel definition layer PDL. First, second, and third barrier wall openings OP1-P, OP2-P, and OP3-P may be defined through the barrier wall PW.

The first, second, and third barrier wall openings OP1-P, OP2-P, and OP3-P may respectively correspond to the first, second, and third light-emitting openings OP1-E, OP2-E, and OP3-E. At least a portion of each of the anodes AE1, AE2, and AE3 may be exposed through a corresponding barrier wall opening among the barrier wall openings OP1-P, OP2-P, and OP3-P.

The barrier wall PW may have an undercut shape when viewed in the cross-section. Each of side surfaces S-L1 and S-L2 of the barrier wall PW, which defines the barrier wall openings OP1-P, OP2-P, and OP3-P, may have an undercut shape when viewed in the cross-section. The barrier wall PW may include a plurality of layers sequentially stacked one on another, and at least one layer among the layers may be recessed more than the other layers stacked adj acent thereto. Accordingly, the barrier wall PW may include the tip portion.

In an embodiment, the barrier wall PW/PWa may have an undercut shape, and the cathode CE may contact an inner side surface of the first barrier wall layer S-L1, which defines the barrier wall opening OP-P/OP-Pa.

The light-emitting patterns EL1, EL2, and EL3 may be separated from each other by the tip portion of the barrier wall PW, may be respectively disposed in the light-emitting openings OP1-E, OP2-E, and OP3-E, and may be respectively disposed in the barrier wall openings OP1-P, OP2-P, and OP3-P, and the cathodes CE1, CE2, and CE3 may be separated from each other by the tip portion of the barrier wall PW and may be respectively disposed in the barrier wall openings OP1-P, OP2-P, and OP3-P.

The barrier wall PW may include a first barrier wall layer L1 and a second barrier wall layer L2 disposed on the first barrier wall layer L1. The first barrier wall layer L1 may define a first area of the barrier wall openings OP1-P, OP2-P, and OP3-P, and the second barrier wall layer L2 may define a second area of the barrier wall openings OP1-P, OP2-P, and OP3-P. In detail, an inner side surface S-L1 of the first barrier wall layer L1 may define the first area of each of the barrier wall openings OP1-P, OP2-P, and OP3-P, and an inner side surface S-L2 of the second barrier wall layer L2 may define the second area of each of the barrier wall openings OP1-P, OP2-P, and OP3-P.

In an embodiment, the first barrier wall layer L1 may be disposed on the pixel definition layer PDL and defining a first area A1 of the barrier wall opening OP-P/OP-Pa and a second barrier wall layer L2 may be disposed on the first barrier wall layer L1, comprising an organic material, and defining a second area A2 of the barrier wall opening OP-P/OP-Pa.

The first barrier wall layer L1 may be disposed on the pixel definition layer PDL. The first barrier wall layer L1 may be more recessed in a horizontal direction than the second barrier wall layer L2 in the light-emitting areas PXA. When viewed in the cross-section, the inner side surface S-L2 of the second barrier wall layer L2, which defines the second area, may be disposed adjacent to a center of each of the anodes AE1, AE2, and AE3 than the inner side surface S-L1 of the first barrier wall layer L1, which defines the first area, is. That is, the inner side surface S-L1 of the first barrier wall layer L1 may be undercut with respect to the inner side surface S-L2 of the second barrier wall layer L2. A portion of the second barrier wall layer L2, which protrudes from the first barrier wall layer L1 to the light-emitting areas PXA-R, PXA-G, and PXA-B, may define the tip portion.

The first barrier wall layer L1 may include a conductive material. The conductive material may include metals, the transparent conductive oxides (TCOs), or alloys thereof. In an embodiment, the metals may include gold (Au), silver (Ag), aluminum (Al), magnesium (Mg), lithium (Li), molybdenum (Mo), titanium (Ti), copper (Cu), or alloys. The transparent conductive oxides may include ITO, IZO, zinc oxide, indium oxide, indium gallium oxide, indium gallium zinc oxide ("IGZO") or aluminum zinc oxide.

The second barrier wall layer L2 may include an organic material and may include a light absorbing material. In an embodiment, the second barrier wall layer L2 may be a carbon layer. In this case, the second barrier wall layer L2 may include graphite, diamond, or polymer. The second barrier wall layer L2 may have a wide refractive index range. Accordingly, the second barrier wall layer L2 having various refractive indices may be used for destructive interference between lights reflected from the barrier wall PW. In an embodiment, the thickness and the refractive index of the second barrier wall layer L2 may be selected by taking into account the thickness and the refractive index of the first barrier wall layer L1. In an embodiment, the second barrier wall layer L2 may comprise a light absorbing material.

The second barrier wall layer L2 may include a first sub-layer L2a having a first refractive index and a second sub-layer L2b having a second refractive index different from the first refractive index. The first refractive index of the first sub-layer L2a and the second refractive index of the second sub-layer L2b may be equal to or greater than about 1.5 and equal to or smaller than about 2.5. The first sub-layer L2a may be disposed on the first barrier wall layer L1, and the second sub-layer L2b may be disposed on the first sub-layer L2a.

According to the disclosure, the second barrier wall layer L2 may include the light absorbing material and may cover an upper surface of the first barrier wall layer L1. In addition, the destructive interference may be generated between the reflected light of the first sub-layer L2a and the reflected light of the second sub-layer L2b by controlling the first refractive index, the second refractive index different from the first refractive index, a thickness of the first sub-layer L2a, and a thickness of the second sub-layer L2b. Accordingly, a reflectance on an upper surface of the second barrier wall layer L2, which corresponds to an upper surface of the barrier wall PW, may be reduced, and thus, a display quality of the display panel DP may be improved.

In addition, the second barrier wall layer L2 may have strong resistance to a chemical etching compared with the first barrier wall layer L1. In an embodiment, the second barrier wall layer L2 may have strong resistance to a fluorine-based gas used in a dry etching process. In this case, an etch rate of the second barrier wall layer L2 may be within a range of about 1 angstrom per second (Å/s) to about 3Å/s. Since the second barrier wall layer L2 is disposed at an uppermost position in the barrier wall PW, damages caused by the etching process on the barrier wall PW may be reduced. In an embodiment, as the display panel DP includes the second barrier wall layer L2, it is possible to prevent a loss of the tip portion formed in the second barrier wall layer L2 and an exposure of the upper surface of the first barrier wall layer L1, which is caused by the etching process.

FIG. 6 shows the structure in which the second barrier wall layer L2 includes the first sub-layer L2a and the second sub-layer L2b, however, the disclosure should not be limited thereto or thereby. The second barrier wall layer L2 may include various structures to generate destructive interference between the reflected light of sub-layers. In an embodiment, the second barrier wall layer may include three or more sub-layers. In addition, FIG. 6 shows the structure in which the inner side surface of the first sub-layer L2a is aligned with the inner side surface of the second sub-layer L2b as an illustrative embodiment, however, the disclosure should not be limited thereto or thereby.

The barrier wall PW may receive the second driving voltage ELVSS (refer to FIG. 4). In an embodiment, since the first barrier wall layer L1 of the barrier wall PW includes the conductive material, the first barrier wall layer L1 may receive the second driving voltage ELVSS. The cathodes CE1, CE2, and CE3 may be directly in contact with the barrier wall PW, e.g., the first barrier wall layer L1, may be electrically connected to the first barrier wall layer L1, and may receive the second driving voltage ELVSS. In an embodiment, the cathodes CE1, CE2, and CE3 may contact the inner side surface S-L1 of the first barrier wall layer L1, which defines the first, second, and third barrier wall openings OP1-P, OP2-P, and OP3-P, and thus, the cathodes CE1, CE2, and CE3 may be electrically connected to each other.

The first barrier wall layer L1 may have a relatively larger thickness than that of the second barrier wall layer L2. The first barrier wall layer L1 may be directly in contact with the first, second, and third cathodes CE1, CE2, and CE3. The first, second, and third cathodes CE1, CE2, and CE3 may be physically separated from each other by the second barrier wall layer L2 forming the tip portion, may be respectively disposed in the light-emitting openings OP1-E, OP2-E, and OP3-E, and may contact the first barrier wall layer L1, and thus, the first, second, and third cathodes CE1, CE2, and CE3 may be electrically connected to each other and may receive the common voltage. As the first barrier wall layer L1 has a relatively high electrical conductivity and relatively large thickness compared with the second barrier wall layer L2, a contact resistance between the first barrier wall layer L1 and the first, second, and third cathodes CE1, CE2, and CE3 may be reduced. Accordingly, a cathode voltage may be commonly and evenly provided to the light-emitting areas PXA-R, PXA-G, and PXA-B.

According to the disclosure, the light-emitting patterns EL1, EL2, and EL3 may be patterned in the unit of pixel by the tip portion defined in the barrier wall PW and may be deposited. That is, the light-emitting patterns EL1, EL2, and EL3 may be formed using an open mask and may be easily separated in the unit of pixel by the barrier wall PW.

In a case where the light-emitting patterns are patterned using a fine metal mask ("FMM"), a support spacer protruded from the barrier wall is desired to support the fine metal mask. In addition, the fine metal mask may be spaced apart from a base surface on which a patterning process is performed by a height of the barrier wall and the spacer, and thus, there may be limitations in implementing the relatively high resolution. In addition, since the fine metal mask contacts the spacer, a foreign substance may remain on the spacer after the patterning process of the light-emitting patterns, or the spacer may be damaged by the fine metal mask that is dented. As a result, a defective display panel may be formed.

In addition, as the display panel DP includes the barrier wall PW, the light-emitting elements ED1, ED2, and ED3 may be easily physically separated from each other. Accordingly, a leakage current or a driving error between the light-emitting areas PXA-R, PXA-G, and PXA-B adjacent to each other may be prevented, and the light-emitting elements ED1, ED2, and ED3 may be driven independently from each other.

In particular, since the light-emitting patterns EL1, EL2, and EL3 are patterned without a mask that contacts components provided inside the display area DA (refer to FIG. 2), the display panel DP with reduced defect and improved process reliability may be provided. Even though the support spacer protruded from the barrier wall PW is not provided, the light-emitting patterns EL1, EL2, and EL3 may be patterned. Therefore, the light-emitting areas PXA-R, PXA-G, and PXA-B may be finely formed in terms of its size, and thus, the display panel DP that is easy to implement in relatively high resolution may be provided.

In addition, the process cost may be reduced since a large-sized mask is not desired when manufacturing a large-sized display panel DP, and the process reliability of the display panel DP may be improved as the display panel is not affected by the defects occurring in the large-sized mask.

In an embodiment of the disclosure, the display panel DP may further include capping patterns. The capping patterns may be respectively disposed in the barrier wall openings OP1-P, OP2-P, and OP3-P and may be disposed on the cathodes CE1, CE2, and CE3. The capping patterns may be patterned by the tip portion formed in the barrier wall PW.

The dummy patterns D1, D2, and D3 may be disposed on the barrier wall PW. The dummy patterns D1, D2, and D3 may include a first dummy pattern D1, a second dummy pattern D2, and a third dummy pattern D3.

The dummy patterns D1, D2, and D3 may include an organic material. In an embodiment, the first, second, and third dummy patterns D1, D2, and D3 may include substantially the same material as that of the first, second, and third light-emitting patterns EL1, EL2, and EL3, respectively. Each dummy pattern may be substantially simultaneously formed with a corresponding light-emitting pattern through a single process and may be formed separately from the corresponding light-emitting pattern by the undercut shape of the barrier wall PW.

First, second, and third dummy openings OP1-D, OP2-D, and OP3-D may be respectively defined through the first, second, and third dummy patterns D1, D2, and D3. The first, second, and third dummy openings OP1-D, OP2-D, and OP3-D may respectively correspond to the first, second, and third light-emitting openings OP1-E, OP2-E, and OP3-E. When viewed in the plane, the first, second, and third dummy patterns D1, D2, and D3 may respectively surround the first, second, and third light-emitting areas PXA-R, PXA-G, and PXA-B, and each of the first, second, and third dummy patterns D1, D2, and D3 may have a closed line shape.

FIG. 6 shows the structure in which an inner side surface of the first dummy pattern D1, which defines the first dummy opening OP1-D, is aligned with an inner side surface S-L2 of the second barrier wall layer L2, which defines the second area of the first barrier wall opening OP1-P, as an illustrative embodiment, however, the disclosure should not be limited thereto or thereby. In an embodiment, the first dummy pattern D1 may cover the inner side surface S-L2 of the second barrier wall layer L2. These descriptions may be applied to the second and third dummy patterns D2 and D3.

The additional dummy patterns D1a, D2a, and D3a may be disposed on the dummy patterns D1, D2, and D3. The additional dummy patterns D1a, D2a, and D3a may include a first additional dummy pattern D1a, a second additional dummy pattern D2a, and a third additional dummy pattern D3a.

Each of the additional dummy patterns D1a, D2a, and D3a may include a conductive material. In an embodiment, the first, second, and third additional dummy patterns D1a, D2a, and D3a may include the same material as that of the first, second, and third cathodes CE1, CE2, and CE3, respectively. Each additional dummy pattern may bs substantially simultaneously formed with a corresponding cathode through a single process and may be formed separately from the corresponding cathode by the undercut shape of the barrier wall PW.

Openings may be respectively defined through the first, second, and third additional dummy patterns D1a, D2a, and D3a to correspond to the first, second, and third light-emitting openings OP1-E, OP2-E, and OP3-E, and when viewed in the plane, the first, second, and third additional dummy patterns D1a, D2a, and D3a may respectively surround the first, second, and third light-emitting areas PXA-R, PXA-G, and PXA-B.

The thin film encapsulation layer TFE may be disposed on the display element layer DP-OLED. The thin film encapsulation layer TFE may include first, second, and third lower encapsulation inorganic patterns LIL1, LIL2, and LIL3, an encapsulation organic layer OL, and an upper encapsulation inorganic layer UIL.

The first lower encapsulation inorganic pattern LIL1 may correspond to the first light-emitting opening OP1-E. The first lower encapsulation inorganic pattern LIL1 may cover the first light-emitting element ED1, the first dummy pattern D1, and the first additional dummy pattern D1a, and a portion of the first lower encapsulation inorganic pattern LIL1 may be disposed inside the first barrier wall opening OP1-P. The first lower encapsulation inorganic pattern LIL1 may contact the first inner side surface S-L1 of the first barrier wall opening OP1-P.

The second lower encapsulation inorganic pattern LIL2 may correspond to the second light-emitting opening OP2-E. The second lower encapsulation inorganic pattern LIL2 may cover the second light-emitting element ED2, the second dummy pattern D2, and the second additional dummy pattern D2a, and a portion of the second lower encapsulation inorganic pattern LIL2 may be disposed inside the second barrier wall opening OP2-P. The second lower encapsulation inorganic pattern LIL2 may contact the first inner side surface S-L1 of the second barrier wall opening OP2-P.

The third lower encapsulation inorganic pattern LIL3 may correspond to the third light-emitting opening OP3-E. The third lower encapsulation inorganic pattern LIL3 may cover the third light-emitting element ED3, the third dummy pattern D3, and the third additional dummy pattern D3a, and a portion of the third lower encapsulation inorganic pattern LIL3 may be disposed inside the third barrier wall opening OP3-P. The third lower encapsulation inorganic pattern LIL3 may contact the first inner side surface S-L1 of the third barrier wall opening OP3-P.

The encapsulation organic layer OL may cover the first, second, and third lower encapsulation inorganic patterns LIL1, LIL2, and LIL3 and may provide a substantially flat upper surface thereon. The upper encapsulation inorganic layer UIL may be disposed on the encapsulation organic layer OL.

The first, second, and third lower encapsulation inorganic patterns LIL1, LIL2, and LIL3 and the upper encapsulation inorganic layer UIL may protect the display element layer DP-OLED from moisture and oxygen, and the encapsulation organic layer OL may protect the display element layer DP-OLED from a foreign substance such as dust particles.

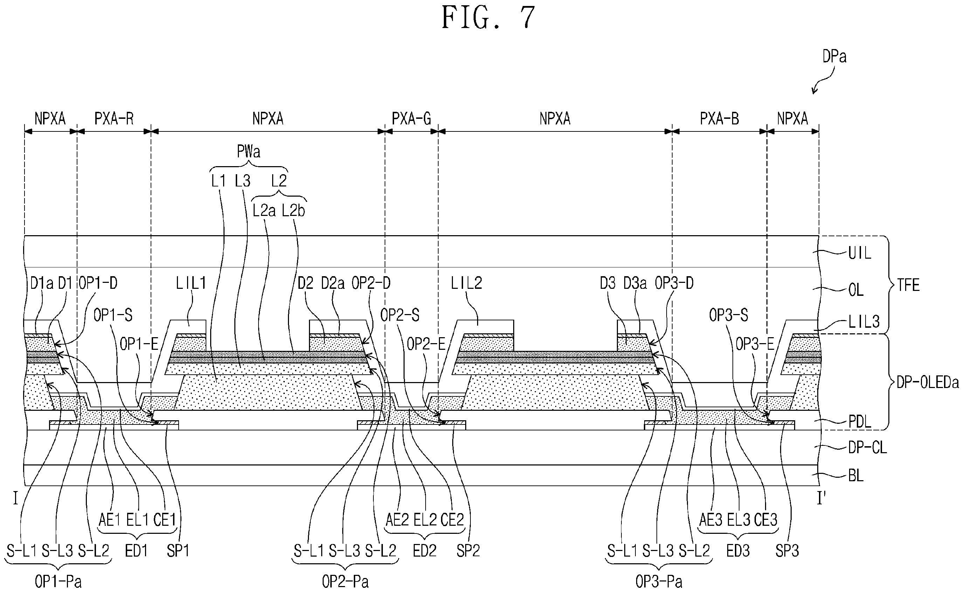

FIG. 7 is a cross-sectional view of an embodiment of a display panel DPa taken along line I-I' of FIG. 5 according to the disclosure. In FIG. 7, the same reference numerals denote the same elements in FIG. 6, and thus, detailed descriptions of the same elements will be omitted.

Referring to FIG. 7, the display panel DPa may include a base layer BL, a circuit element layer DP-CL, a display element layer DP-OLEDa, and a thin film encapsulation layer TFE. The display element layer DP-OLEDa may include light-emitting elements ED1, ED2, and ED3, a pixel definition layer PDL, a barrier wall PWa, dummy patterns D1, D2, and D3, and additional dummy patterns D1a, D2a, and D3a. When compared with the display panel DP of FIG. 6, there may be a difference in structure of the barrier wall PWa of the display panel DPa of FIG. 7.

The barrier wall PWa may be disposed on the pixel definition layer PDL. First, second, and third barrier wall openings OP1-Pa, OP2-Pa, and OP3-Pa may be defined through the barrier wall PWa. The first, second, and third barrier wall openings OP1-Pa, OP2-Pa, and OP3-Pa may correspond to first, second, and third light-emitting openings OP1-E, OP2-E, and OP3-E, respectively. Each of the first, second, and third barrier wall openings OP1-Pa, OP2-Pa, and OP3-Pa may expose at least a portion of a corresponding anode of anodes AE1, AE2, and AE3.

The barrier wall PWa may include a first barrier wall layer L1, a second barrier wall layer L2 disposed on the first barrier wall layer L1, and a third barrier wall layer L3 disposed between the first barrier wall layer L1 and the second barrier wall layer L2.

The first barrier wall layer L1 may define a first area of the barrier wall openings OP1-Pa, OP2-Pa, and OP3-Pa, and the second barrier wall layer L2 and the third barrier wall layer L3 may defined a second area of the barrier wall openings OP1-Pa, OP2-Pa, and OP3-Pa. In detail, an inner side surface S-L1 of the first barrier wall layer L1 may define the first area of each of the barrier wall openings OP1-Pa, OP2-Pa, and OP3-Pa, and an inner side surface S-L2 of the second barrier wall layer L2 and an inner side surface S-L3 of the third barrier wall layer L3 may define the second area of each of the barrier wall openings OP1-Pa, OP2-Pa, and OP3-Pa. That is, the inner side surface S-L3 of the third barrier wall layer L3 may be aligned with the inner side surface S-L2 of the second barrier wall layer L2.

The first barrier wall layer L1 may be disposed on the pixel definition layer PDL. The first barrier wall layer L1 may be more recessed in a horizontal direction than the second barrier wall layer L2 and the third barrier wall layer L3 with respect to the light-emitting areas PXA-R, PXA-G, and PXA-B. When viewed in the cross-section, the inner side surface S-L2 of the second barrier wall layer L2 and the inner side surface S-L3 of the third barrier wall layer L3, which define the second area, may be disposed closer to a center of each of the anodes AE1, AE2, and AE3 than the inner side surface S-L1 of the first barrier wall layer L1, which defines the first area, is to the center of the anode. That is, the inner side surface S-L1 of the first barrier wall layer L1 may be undercut with respect to the inner side surface S-L2 of the second barrier wall layer L2 and the inner side surface S-L3 of the third barrier wall layer L3. A portion of the second barrier wall layer L2 and the third barrier wall layer L3, which protrudes from the first barrier wall layer L1 to the light-emitting areas PXA-R, PXA-G, and PXA-B, may define a tip portion.

The third barrier wall layer L3 may include an inorganic material. The third barrier wall layer L3 may include metals, transparent conductive oxides (TCOs), or non-metals. In an embodiment, the third barrier wall layer L3 may include gold (Au), silver (Ag), aluminum (Al), magnesium (Mg), lithium (Li), molybdenum (Mo), titanium (Ti), copper (Cu), or alloys and may include silicon (Si), silicon oxide (SiOx), silicon nitride (SiNx), silicon oxynitride (SiON), metal oxides, metal nitrides, or any combinations thereof.

The second barrier wall layer L2 may include an organic material and may include a light absorbing material. In an embodiment, the second barrier wall layer L2 may be a carbon layer. In this case, the second barrier wall layer L2 may include graphite, diamond, or polymer. The second barrier wall layer L2 may have a wide refractive index range. Accordingly, the second barrier wall layer L2 having various refractive indices may be used for destructive interference between lights reflected from the barrier wall PWa. In an embodiment, the thickness and the refractive index of the second barrier wall layer L2 may be selected by taking into account a thickness and a refractive index of the first barrier wall layer L1 and the third barrier wall layer L3.

The second barrier wall layer L2 may include a first sub-layer L2a having a first refractive index and a second sub-layer L2b having a second refractive index different from the first refractive index. The refractive index of the second barrier wall layer L2 may be different from the refractive index of the third barrier wall layer L3. The first refractive index of the first sub-layer L2a and the second refractive index of the second sub-layer L2b may be equal to or greater than about 1.5 and equal to or smaller than about 2.5. The first sub-layer L2a may be disposed on the third barrier wall layer L3, and the second sub-layer L2b may be disposed on the first sub-layer L2a.

The first barrier wall layer L1 may have a first conductivity, and the third barrier wall layer L3 may have a second conductivity lower than the first conductivity. The first barrier wall layer L1 may have an etch rate greater than an etch rate of the second barrier wall layer L2. That is, the first barrier wall layer L1 may include a material having an etch selectivity with respect to the second barrier wall layer L2.

According to the disclosure, the second barrier wall layer L2 may include a light absorbing material and may cover an upper surface of the third barrier wall layer L3. In addition, destructive interference may be generated between a light reflected by the third barrier wall layer L3 and a light reflected by the second barrier wall layer L2 by controlling the first refractive index, the second refractive index different from the first refractive index, the thickness of the first sub-layer L2a, and the thickness of the second sub-layer L2b. Accordingly, a reflectance on an upper surface of the second barrier wall layer L2, which corresponds to an upper surface of the barrier wall PWa, may be reduced, and thus, the display quality of the display panel DPa may be improved.

In addition, the second barrier wall layer L2 may have strong resistance to a chemical etching compared with the third barrier wall layer L3. In an embodiment, the second barrier wall layer L2 may have strong resistance to a fluorine-based gas used in a dry etching process. In this case, an etch rate of the second barrier wall layer L2 may be within a range of about 1Å/s to about 3Å/s. Since the second barrier wall layer L2 is disposed at an uppermost position in the barrier wall PWa, damages caused by the etching process on the barrier wall PWa may be reduced. In detail, as the display panel DPa includes the second barrier wall layer L2, it is possible to prevent the loss of the tip portion formed in the third barrier wall layer L3, and it is possible to prevent the third barrier wall layer L3 overlapping a peripheral area NPXA from being etched. Accordingly, the exposure of the upper surface of the first barrier wall layer L1, which is caused by the damage of the third barrier wall layer L3, may be prevented.

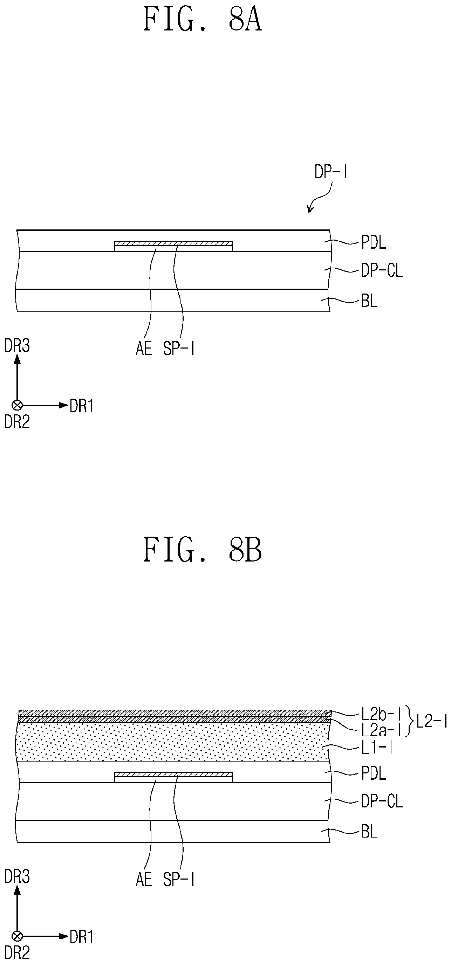

FIGS. 8A to 8I are cross-sectional views illustrating an embodiment of a method of manufacturing the display panel according to the disclosure. In FIGS. 8A to 8I, the same reference numerals denote the same elements in FIGS. 1 to 6, and thus, detailed descriptions of the same elements will be omitted. FIGS. 8A to 8I show some processes of the manufacturing method of the display panel DP of FIG. 6.

The manufacturing method of the display panel may include providing a preliminary display panel including the base layer, the anode disposed on the base layer, and the pixel definition layer which is disposed on the base layer and through which the light-emitting opening is defined therethrough to expose the portion of the anode, forming a first preliminary barrier wall layer on the preliminary display panel, forming a second preliminary barrier wall layer including an organic material on the first preliminary barrier wall layer, etching the first and second preliminary barrier wall layers to form the barrier wall through which the barrier wall opening is defined, and forming the cathode that contacts the light-emitting pattern and the barrier wall in the barrier wall opening.

Hereinafter, a method of forming one light-emitting element ED, the lower encapsulation inorganic pattern LIL, the encapsulation organic layer OL, and the upper encapsulation inorganic layer UIL, which cover the light-emitting element ED, will be described with reference to FIGS. 8A to 8I. Descriptions on the method of forming the one light-emitting element ED may be substantially the same as descriptions on a method of forming the first, second, and third light-emitting elements ED 1, ED2, and ED3 (refer to FIG. 6).

Referring to FIG. 8A, the manufacturing method of the display panel may include providing the preliminary display panel DP-I. The preliminary display panel DP-I may include the base layer BL, the circuit element layer DP-CL, the anode AE, a preliminary sacrificial pattern SP-I, and the pixel definition layer PDL.

The anode AE may be disposed on the base layer BL. The pixel definition layer PDL may be disposed on the base layer BL and through which a light-emitting opening OP-E may be defined to expose a portion of the anode AE.

The circuit element layer DP-CL may be formed by forming the insulating layer, the semiconductor layer, and the conductive layer using a coating or depositing process and selectively patterning the insulating layer, the semiconductor layer, and the conductive layer using a photolithography process to form the semiconductor pattern, the conductive pattern, and the signal line.

The anode AE and the preliminary sacrificial pattern SP-I may be formed by the same patterning process. The pixel definition layer PDL may cover the anode AE and the preliminary sacrificial pattern SP-I.

Then, referring to FIG. 8B, the manufacturing method of the display panel may include forming a first preliminary barrier wall layer L1-I and forming a second preliminary barrier wall layer L2-I.

The first preliminary barrier wall layer L1-I may be formed on the pixel definition layer PDL of the preliminary display panel DP-I (refer to FIG. 8A). The forming of the first preliminary barrier wall layer L1-I may be carried out by performing a deposition process on a conductive material. In an embodiment, the forming of the first preliminary barrier wall layer L1-I may be performed using a sputtering deposition process.

The second preliminary barrier wall layer L2-I may be formed on the first preliminary barrier wall layer L1-1. The second preliminary barrier wall layer L2-I may include the organic material and the light absorbing material. In an embodiment, the second barrier wall layer L2 may be the carbon layer. In this case, the second barrier wall layer L2 may include graphite, diamond, or polymer.

The forming of the second preliminary barrier wall layer L2-I may include forming a first preliminary sub-layer L2a-I on the first preliminary barrier wall layer L1-I and forming a second preliminary sub-layer L2b-I on the first preliminary sub-layer L2a-I. The first preliminary sub-layer L2a-I may have a first refractive index, and the second preliminary sub-layer L2b-I may have a second refractive index different from the first refractive index. The forming of the second preliminary barrier wall layer L2-I may be carried out by performing a deposition process on the conductive material. In an embodiment, the forming of the second preliminary barrier wall layer L2-I may be performed using a sputtering deposition process.

In an embodiment, forming the second preliminary barrier wall layer L2-I may comprise forming a first preliminary sub-layer L2a-I having a first refractive index on the first preliminary barrier wall layer L1-I and forming a second preliminary sub-layer L2bI having a second refractive index different from the first refractive index on the first preliminary sub-layer L2a-I.

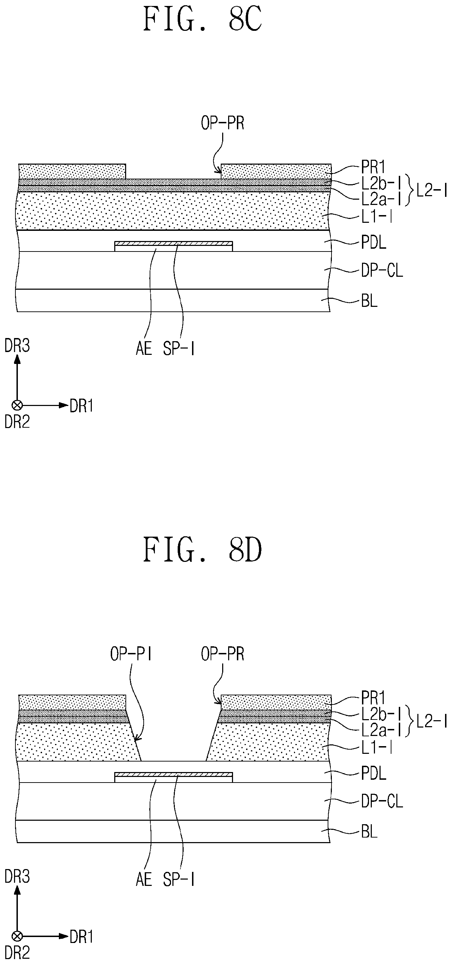

Then, referring to FIG. 8C, the manufacturing method of the display panel may include forming a first photoresist layer PR1 on the first and second preliminary barrier wall layers L1-I and L2-I. The first photoresist layer PR1 may be formed by forming a preliminary photoresist layer on the first and second preliminary barrier wall layers L1-I and L2-I and patterning the preliminary photoresist layer using a photomask. Through the patterning process, a photo opening OP-PR may be defined through the first photoresist layer PR1 to overlap the anode AE.

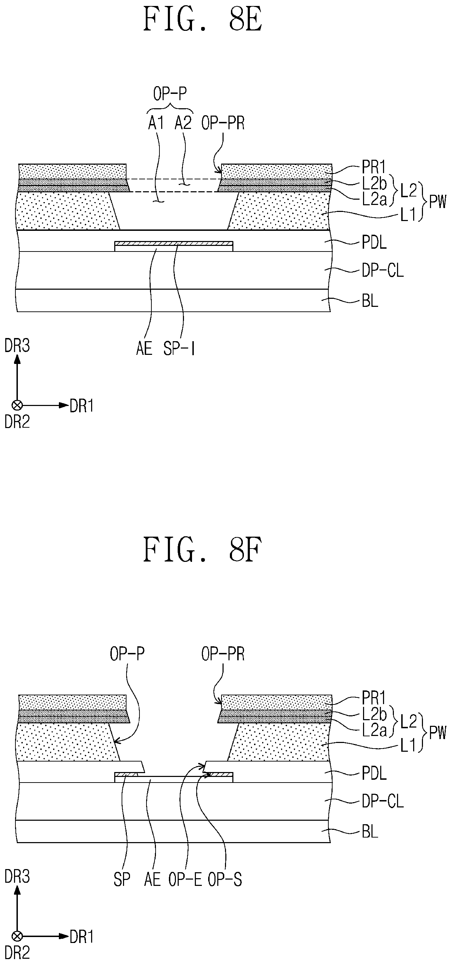

Referring to FIGS. 8D and 8E, the manufacturing method of the display panel may include etching the first preliminary barrier wall layer L1-I and the second preliminary barrier wall layer L2-I to form the barrier wall PW through which a barrier wall opening OP-P is defined.

Referring to FIG. 8D, the forming of the barrier wall PW may include etching (hereinafter, also referred to as a first etching or a first dry etching) the first and second preliminary barrier wall layers L1-I and L2-I. The first etching of the first and second preliminary barrier wall layers L1-I and L2-I may include dry etching the first and second preliminary barrier wall layers L1-I and L2-I using the first photoresist layer PR1 as a mask to define a preliminary barrier wall opening OP-PI.

In the illustrated embodiment, the first dry etching process may be performed in an etching environment where the first preliminary barrier wall layer L1-I and the second preliminary barrier wall layer L2-I have substantially the same etch selectivity. Accordingly, an inner side surface of the first preliminary barrier wall layer L1-I and an inner side surface of the second preliminary barrier wall layer L2-I, which define the preliminary barrier wall opening OP-PI, may be aligned with each other.

Then, referring to FIG. 8E, the forming of the barrier wall PW may include an etching (hereinafter, also referred to as a second etching or a second wet etching) the first preliminary barrier wall layer L1-I (refer to FIG. 8D) to form the first barrier wall layer L1 and the second barrier wall layer L2. The second etching of the first preliminary barrier wall layer L1-I may include wet etching the first preliminary barrier wall layer L1-I using the first photoresist layer PR1 as a mask to define the barrier wall opening OP-P from the preliminary barrier wall opening OP-PI (refer to FIG. 8D).

The barrier wall opening OP-P may be provided with a first area A1 and a second area A2, which are defined therein and sequentially disposed in a thickness direction (i.e., the third direction DR3). The first barrier wall layer L1 may define the first area A1 of the barrier wall opening OP-P, and the second barrier wall layer L2 may define the second area A2 having a width different from a width of the first area A1.

In the illustrated embodiment, the second wet etching process may be performed in an etching environment where the first preliminary barrier wall layer L1-I has an etch selectivity to the second preliminary barrier wall layer L2-I. Accordingly, the inner side surface of the barrier wall PW defining the barrier wall opening OP-P may have the undercut shape when viewed in the cross-section. In detail, since an etch rate of the first preliminary barrier wall layer L1-I with respect to an etching solution is greater than an etch rate of the second preliminary barrier wall layer L2-I with respect to the etching solution, the first preliminary barrier wall layer L1-I may be mainly etched. Accordingly, the first inner side surface of the first barrier wall layer L1 may be more recessed inward than the second inner side surface of the second barrier wall layer L2. The tip portion may be formed in the barrier wall PW by the portion of the second barrier wall layer L2 protruded from the first barrier wall layer L1.

Referring to FIG. 8F, the manufacturing method of the display panel may include etching the pixel definition layer PDL and etching the preliminary sacrificial pattern SP-I.

The etching of the pixel definition layer PDL may be performed by a dry etching method, and the pixel definition layer PDL may be etched using the first photoresist layer PR1 and the barrier wall PW, e.g., the second barrier wall layer L2, as a mask. A light-emitting opening OP-E corresponding to the barrier wall opening OP-P may be defined through the pixel definition layer PDL.

According to the disclosure, as the second barrier wall layer L2 include the organic material, the second barrier wall layer L2 may have the strong resistance to a chemical etching. In an embodiment, the second barrier wall layer L2 may have the strong resistance to the fluorine-based gas used in the dry etching process. In this case, the etch rate of the second barrier wall layer L2 may be within the range of about 1Å/s to about 3Å/s. Accordingly, even though the pixel definition layer PDL is etched using the second barrier wall layer L2 as the mask, damages on the barrier wall PW may be reduced, and the loss of the tip portion formed in the second barrier wall layer L2 may be prevented.

The etching process of the preliminary sacrificial pattern SP-I may be performed by the wet etching method, and the preliminary sacrificial pattern SP-I may be etched using the first photoresist layer PR1 and the barrier wall PW, e.g., the second barrier wall layer L2, as the mask. A sacrificial opening OP-S overlapping the light-emitting opening OP-E may be defined through the sacrificial pattern SP obtained by etching the preliminary sacrificial pattern SP-I. At least a portion of the anode AE may be exposed through the sacrificial opening OP-S and the light-emitting opening OP-E without being covered by the sacrificial pattern SP and the pixel definition layer PDL.

The etching process of the sacrificial pattern SP may be performed in the environment in which the sacrificial pattern SP has an etch selectivity to the anode AE, and thus, it is possible to prevent the anode AE from being etched. That is, since the sacrificial pattern SP having the etch rate greater than that of the anode AE is disposed between the pixel definition layer PDL and the anode AE, the anode AE may be prevented from being etched and damaged during the etching process.

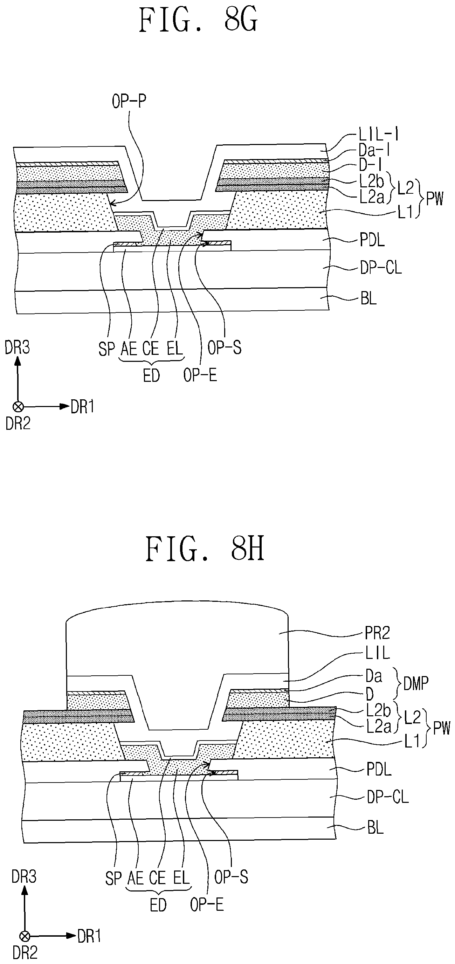

Referring to FIG. 8G, the manufacturing method of the display panel may include removing the first photoresist layer PR1 (refer to FIG. 8F), forming the light-emitting pattern EL, forming the cathode CE, and forming the preliminary lower encapsulation inorganic pattern LIL-I.

The forming of the light-emitting pattern EL and the forming of the cathode CE may be performed through a deposition process. In an embodiment, the forming of the light-emitting pattern EL may be performed by a thermal evaporation process, and the forming of the cathode CE may be performed by a sputtering process, however, the disclosure should not be limited thereto or thereby.

In the forming of the light-emitting pattern EL, the light-emitting pattern EL may be separated by the tip portion formed in the barrier wall PW and may be disposed in the light-emitting opening OP-E and the barrier wall opening OP-P. In the forming of the light-emitting pattern EL, a dummy layer D-I may be formed spaced apart from the light-emitting pattern EL on the barrier wall PW.

In the forming of the cathode CE, the cathode CE may be separated by the tip portion formed in the barrier wall PW and may be disposed in the barrier wall opening OP-P. The cathode CE may be provided at an incident angle higher than that of the light-emitting pattern EL, and thus, the cathode CE may be formed to contact the first inner side surface of the first barrier wall layer L1. In the forming of the cathode CE, an additional dummy layer Da-I may be formed spaced apart from the cathode CE on the barrier wall PW. The anode AE, the light-emitting pattern EL, and the cathode CE may form the light-emitting element ED.

The preliminary lower encapsulation inorganic pattern LIL-I may be formed by a deposition process. The preliminary lower encapsulation inorganic pattern LIL-I may be formed by a chemical vapor deposition ("CVD") process. The preliminary lower encapsulation inorganic pattern LIL-I may be formed on the barrier wall PW and the cathode CE, and a portion of the preliminary lower encapsulation inorganic pattern LIL-I may be formed inside the barrier wall opening OP-P.

Referring to FIG. 8H, the manufacturing method of the display panel may include forming a second photoresist layer PR2, etching the preliminary lower encapsulation inorganic pattern LIL-1 (refer to FIG. 8G) to form the lower encapsulation inorganic pattern LIL, and etching the dummy layer D-I (refer to FIG. 8G) and the additional dummy layer Da-I (refer to FIG. 8G) to form a dummy pattern DMP.

In the forming of the second photoresist layer PR2, the second photoresist layer PR2 may be formed by forming a preliminary photoresist layer and patterning the preliminary photoresist layer using the photomask. Through the patterning process, the second photoresist layer PR2 may be formed in a pattern shape corresponding to the light-emitting opening OP-E.

The forming of the lower encapsulation inorganic pattern LIL may be performed by the dry etching method to remove portions of the preliminary lower encapsulation inorganic pattern LIL-I, which overlap other anodes except the corresponding anode AE thereto. In an embodiment, in a case where the preliminary lower encapsulation inorganic pattern LIL-I corresponds to the first anode AE1 (refer to FIG. 6), the portions of the preliminary lower encapsulation inorganic pattern LIL-I, which overlap the second and third anodes AE2 and AE3 (refer to FIG. 6), may be removed.

The lower encapsulation inorganic pattern LIL overlapping the corresponding light-emitting opening OP-E may be formed from the preliminary lower encapsulation inorganic pattern LIL-I. A portion of the lower encapsulation inorganic pattern LIL may be disposed in the barrier wall opening OP-P to cover the light-emitting element ED, and the other portion of the lower encapsulation inorganic pattern LIL may be disposed on the barrier wall PW.

The forming of the dummy pattern DMP may be performed by a dry etching to remove portions of the dummy layer D-I (refer to FIG. 8G) and portions of the additional dummy layer Da-I (refer to FIG. 8G), which overlap other anodes except the corresponding anode AE thereto. In an embodiment, in a case where the dummy layer D-I and the additional dummy layer Da-I correspond to the first anode AE1, the portions of the dummy layer D-I and the portions of the additional dummy layer Da-I, which overlap the second and third anodes AE2 and AE3, may be removed.

The dummy pattern DMP overlapping the corresponding light-emitting opening OP-E may be formed from the etched dummy layer D-I and the etched additional dummy layer Da-I. The dummy pattern DMP may be disposed on the barrier wall PW and may have a closed-line shape surrounding the corresponding light-emitting area PXA (refer to FIG. 5) when viewed in the plane.

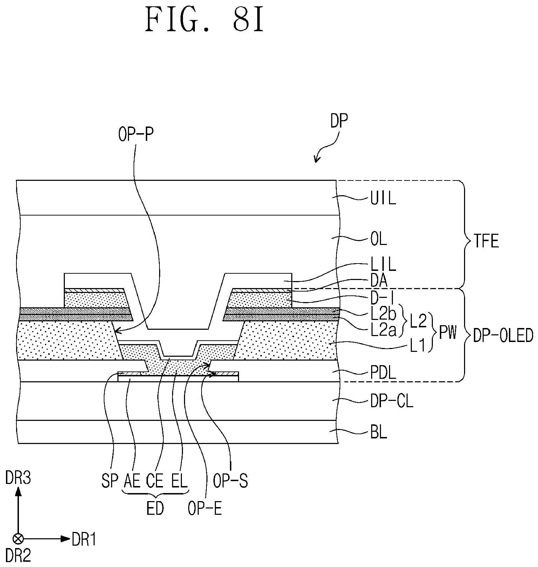

Referring to FIG. 8I, the manufacturing method of the display panel may include forming the encapsulation organic layer OL and the upper encapsulation inorganic layer UIL after removing the second photoresist layer PR2 (refer to FIG. 8H) to complete the display panel DP. The encapsulation organic layer OL may be formed by coating the organic material using an inkjet method, however, the disclosure should not be limited thereto or thereby. The encapsulation organic layer OL may provide the substantially flat upper surface thereon. Then, the upper encapsulation inorganic layer UIL may be formed by depositing the inorganic material. As a result, the display panel DP that includes the base layer BL, the circuit element layer DP-CL, the display element layer DP-OLED, and the thin film encapsulation layer TFE may be formed.

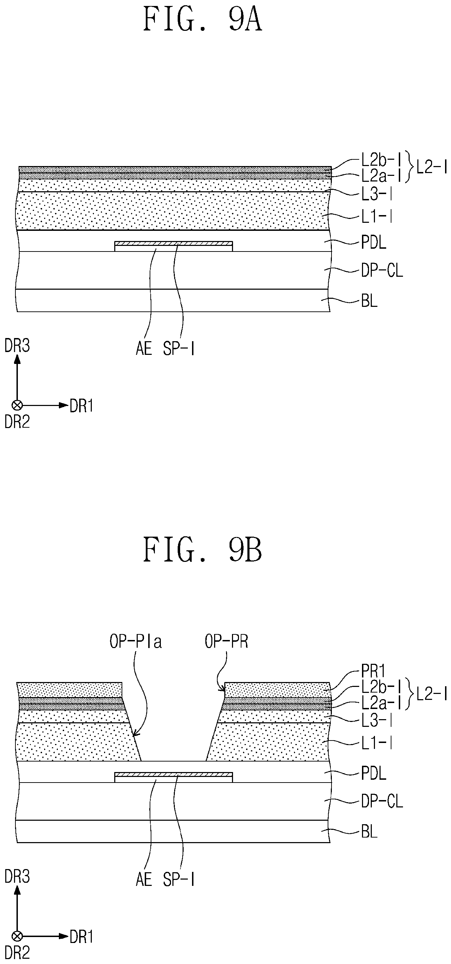

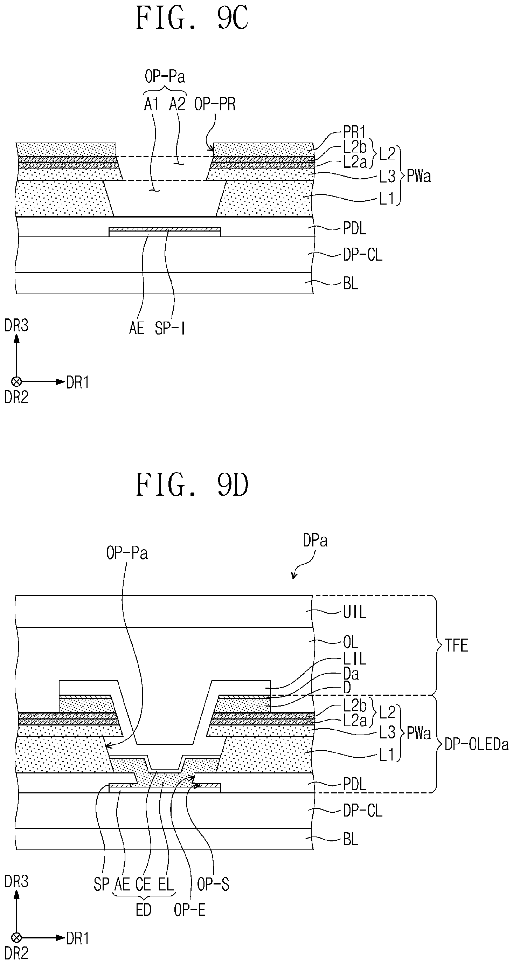

FIGS. 9A to 9D are cross-sectional views illustrating an embodiment of a method of manufacturing the display panel according to the disclosure. In FIGS. 9A to 9D, the same reference numerals denote the same elements in FIGS. 1 to 5 and 7, and thus, detailed descriptions of the same elements will be omitted. FIGS. 9A to 9D show some processes of the manufacturing method of the display panel DPa of FIG. 7.

In the manufacturing method of the display panel DPa of FIG. 7, a process of providing a preliminary display panel may be substantially the same as the providing of the preliminary display panel DP-I of FIG. 8A.

Referring to FIG. 9A, the manufacturing method of the display panel may include forming a first preliminary barrier wall layer L1-I, forming a third preliminary barrier wall layer L3-I, and forming a second preliminary barrier wall layer L2-I.

The first preliminary barrier wall layer L1-I may be formed on a pixel definition layer PDL of a preliminary display panel DP-I (refer to FIG. 8A). The forming of the first preliminary barrier wall layer L1-I may be carried out by performing a deposition process on the conductive material. In an embodiment, the forming of the first preliminary barrier wall layer L1-I may be performed by a sputtering deposition process.

The third preliminary barrier wall layer L3-I may be formed on the first preliminary barrier wall layer L1-I. The third preliminary barrier wall layer L3-I may include an inorganic material. The third barrier wall layer L3 may include metals, TCO, or non-metals.

The second preliminary barrier wall layer L2-I may be formed on the third preliminary barrier wall layer L3-I. The second preliminary barrier wall layer L2-I may include an organic material and may include a light absorbing material. In an embodiment, the second barrier wall layer L2 may be a carbon layer. In this case, the second preliminary barrier wall layer L2-I may include graphite, diamond, or polymer.

The forming of the second preliminary barrier wall layer L2-I may include forming a first preliminary sub-layer L2a-I on the third preliminary barrier wall layer L3-I and forming a second preliminary sub-layer L2b-I on the first preliminary sub-layer L2a-I. The first preliminary sub-layer L2a-I may have a first refractive index, and the second preliminary sub-layer L2b-I may have a second refractive index different from the first refractive index. The second preliminary barrier wall layer L2-I may have a refractive index different from a refractive index of the third preliminary barrier wall layer L3-I. The forming of the second preliminary barrier wall layer L2-I may be carried out by performing the deposition process on the conductive material. In an embodiment, the forming of the second preliminary barrier wall layer L2-I may be performed by a sputtering deposition process.

In the manufacturing method of the display panel DPa of FIG. 7, a process of forming a first photoresist layer PR1 (refer to FIG. 9B) may be substantially the same as the forming of the first photoresist layer PR1 of FIG. 8C.

Referring to FIGS. 9B and 9C, the manufacturing method of the display panel may include etching the first preliminary barrier wall layer L1-I to form a barrier wall PWa through which a barrier wall opening OP-Pa is formed, etching the second preliminary barrier wall layer L2-I, and etching the third preliminary barrier wall layer L3-I.

Referring to FIG. 9B, the forming of the barrier wall PWa may include etching (hereinafter, also referred to as a first etching or a first dry etching) the first preliminary barrier wall layer L1-I, the second preliminary barrier wall layer L2-I, and the third preliminary barrier wall layer L3-I. The first etching of the first, second, and third preliminary barrier wall layers L1-I, L2-I, and L3-I may include dry etching the first, second, and third preliminary barrier wall layers L1-I, L2-I, and L3-I using a first photoresist layer PR1 as a mask to define a preliminary barrier wall opening OP-PIa.

In the illustrated embodiment, the first dry etching process may be performed in an etching environment in which the first preliminary barrier wall layer L1-I, the second preliminary barrier wall layer L2-I, and the third preliminary barrier wall layer L3-I have the same etch selectivity. Accordingly, an inner side surface of the first preliminary barrier wall layer L1-I, which defines the preliminary barrier wall opening OP-PIa, an inner side surface of the second preliminary barrier wall layer L2-I, and an inner side surface of the third preliminary barrier wall layer L3-I may be substantially aligned with each other.

Referring to FIG. 9C, the forming of the barrier wall PWa may include etching (hereinafter, also referred to as a second etching or a second wet etching) the first preliminary barrier wall layer L1-I (refer to FIG. 9B) to form the first barrier wall layer L1, the second barrier wall layer L2, and the third barrier wall layer L3. The second etching of the first preliminary barrier wall layer L1-I may include wet etching the first preliminary barrier wall layer L1-I using the first photoresist layer PR1 as a mask to define the barrier wall opening OP-Pa from the preliminary barrier wall opening OP-PIa (refer to FIG. 9B).

The barrier wall opening OP-Pa may be provided with a first area A1 and a second area A2, which are defined therein and sequentially disposed in a thickness direction (i.e., the third direction DR3). The first barrier wall layer L1 may define the first area A1 of the barrier wall opening OP-Pa, and the second barrier wall layer L2 and the third barrier wall layer L3 may define the second area A2 having a width different from a width of the first area A1.

In the illustrated embodiment, the second wet etching process may be performed in an etching environment where the first preliminary barrier wall layer L1-Ihas the etch selectivity to the second preliminary barrier wall layer L2-I and the third preliminary barrier wall layer L3-I. Accordingly, the inner side surface of the barrier wall PWa defining the barrier wall opening OP-Pa may have the undercut shape when viewed in the cross-section. In detail, since an etch rate of the first preliminary barrier wall layer L1-I with respect to an etching solution is greater than an etch rate of the second and third preliminary barrier wall layers L2-I and L3-I with respect to the etching solution, the first preliminary barrier wall layer L1-I may be mainly etched. Accordingly, the first inner side surface of the first barrier wall layer L1 may be more recessed inward than the second and third inner side surfaces of the second and third barrier wall layers L2 and L3. A tip portion may be formed in the barrier wall PWa by portions of the second and third barrier wall layers L2 and L3 protruded from the first barrier wall layer L1.

In the manufacturing method of the display panel DPa of FIG. 7, a process of etching the pixel definition layer PDL, a process of etching a preliminary sacrificial pattern SP-I, a process of forming a light-emitting pattern EL after removing the first photoresist layer PR1, a process of forming a cathode CE, and a process of forming a thin film encapsulation layer TFE may be substantially the same as those of the manufacturing method of the display panel described with reference to FIGS. 8F to 8I.

The disclosed subject matter should not be limited to any single embodiment described herein, and the scope of the inventive concept shall be determined according to the attached claims.

## Claims

1. A display panel (DP, DPa) comprising:
a base layer (BL);
a pixel definition layer (PDL) which is disposed on the base layer (BL) and through which a light-emitting opening (OP-E) is defined;
a barrier wall (PW, PWa) which is disposed on the pixel definition layer (PDL) and in which a barrier wall opening (OP-P, OP-Pa) corresponding to the light-emitting opening (OP-E) is defined, the barrier wall (PW, PWa) comprising:
a first barrier wall layer (L1) disposed on the pixel definition layer (PDL) and defining a first area (A1) of the barrier wall opening (OP-P, OP-Pa); and
a second barrier wall layer (L2) disposed on the first barrier wall layer (L1), comprising an organic material, and defining a second area (A2) of the barrier wall opening (OP-P, OP-Pa); and
a light-emitting element (ED) disposed in the barrier wall opening (OP-P, OP-Pa) and comprising an anode (AE), an intermediate layer, and a cathode (CE) which contacts the barrier wall (PW, PWa).

2. The display panel (DP, DPa) of claim 1, wherein the second barrier wall layer (L2) comprises a light absorbing material.

3. The display panel (DP) of claim 1, wherein the second barrier wall layer (L2) comprises:
a first sub-layer (L2a) having a first refractive index; and
a second sub-layer (L2b) disposed on the first sub-layer (L2a) and having a second refractive index different from the first refractive index.

4. The display panel (DP, DPa) of claim 3, wherein the first refractive index of the first sub-layer (L2a) and the second refractive index of the second sub-layer (L2b) are equal to or greater than about 1.5 and equal to or smaller than about 2.5.

5. The display panel (DP, DPa) of claim 1, wherein an inner side surface of the second barrier wall layer (S-L2), which defines the second area (A2), is disposed closer to a center of the anode than an inner side surface of the first barrier wall layer (S-L1), which defines the first area (A1), is to the center of the anode (AE) in a cross-section.

6. The display panel (DP, DPa) of claim 1, wherein the barrier wall (PW, PWa) has an undercut shape, and the cathode (CE) contacts an inner side surface of the first barrier wall layer (S-L1), which defines the barrier wall opening (OP-P, OP-Pa).

7. The display panel (DP, DPa) of claim 1, wherein the barrier wall (PW, PWa) further comprises a third barrier wall layer (L3) disposed between the first barrier wall layer (L1) and the second barrier wall layer (L2), comprising an inorganic material, and defining the second area (A2).

8. The display panel (DP, DPa) of claim 7, wherein an inner side surface (S-L3) of the third barrier wall layer (L3), which defines the second area (A2), is aligned with an inner side surface (S-L2) of the second barrier wall layer (L2), which defines the second area (A2).

9. The display panel (DP, DPa) of claim 7, wherein the second barrier wall layer (L2) has a refractive index different from a refractive index of the third barrier wall layer (L3).

10. The display panel (DP, DPa) of claim 7, wherein the second barrier wall layer (L2) covers an upper surface of the third barrier wall layer (L3).

11. The display panel (DP, DPa) of claim 10, wherein the second barrier wall layer (L2) includes a light absorbing material.

12. A method of manufacturing a display panel (DP, DPa), the method comprising:
providing a preliminary display panel (DP-I) comprising a base layer (BL), an anode (AE) disposed on the base layer (BL), and a pixel definition layer (PDL) which is disposed on the base layer (BL) and through which a light-emitting opening (OP-E) is defined to expose a portion of the anode (AE);
forming a first preliminary barrier wall layer (L1-I) on the preliminary display panel (DP-I);
forming a second preliminary barrier wall layer (L2-I) comprising an organic material on the first preliminary barrier wall layer (L1-I);
etching the first and second preliminary barrier wall layers (L1-I, L2-I) to form a barrier wall (PW, PWa) through which a barrier wall opening (OP-P, OP-Pa) is defined; and
forming a light-emitting pattern (EL) and a cathode (CE) in the barrier wall opening (OP-P, OP-Pa), the cathode (CE) being in contact with the barrier wall (PW, PWa).

13. The method of claim 11, wherein the forming the second preliminary barrier wall layer (L2-I) comprises:
forming a first preliminary sub-layer (L2a-I) having a first refractive index on the first preliminary barrier wall layer (L1-I); and
forming a second preliminary sub-layer (L2b-I) having a second refractive index different from the first refractive index on the first preliminary sub-layer (L2a-I).

14. The method of claim 13, wherein the etching the first and second preliminary barrier wall layers (L1-I, L2-I) to form the barrier wall (PW, PWa) through which the barrier wall opening (OP-P, OP-Pa) is defined comprises:
first etching the first and second preliminary barrier wall layers (L1-I, L2-I); and
second etching the first preliminary barrier wall layer (L1-I) to form a first barrier wall layer (L1) and a second barrier wall layer (L2),
wherein the first barrier wall layer (L1) defines a first area (A1) of the barrier wall opening (OP-P, OP-Pa), and the second barrier wall layer (L2) defines a second area (A2) having a width different from a width of the first area (A1) of the barrier wall opening (OP-P, OP-Pa).

15. The method of claim 14, further comprising:
forming a third preliminary barrier wall layer (L3-I) on the first preliminary barrier wall layer (L1-I); and
etching the third preliminary barrier wall layer (L3-I) to form the barrier wall (PW, PWa) through which the barrier wall opening (OP-P, OP-Pa) is defined, wherein the forming the barrier wall (PW, PWa) comprises:
first etching the first preliminary barrier wall layer (L1-I), the second preliminary barrier wall layer (L2-I), and the third preliminary barrier wall layer (L3-I); and
second etching the first preliminary barrier wall layer (L1-I) to form a first barrier wall layer (L1), a second barrier wall layer (L2), and a third barrier wall layer (L3),
wherein the first barrier wall layer (L1) defines a first area (A1) of the barrier wall opening (OP-P, OP-Pa), and the second barrier wall layer (L2) and the third barrier wall layer (L3) define a second area (A2) having a width different from a width of the first area (A1) of the barrier wall opening (PW, PWa).
